# EUROPEAN PATENT APPLICATION

(11) **EP 1 850 486 A1**
(43) Date of publication of application: **31.10.2007**
(21) Application number: 06713007.0
(22) Date of filing: 03.02.2006
(51) Int. Cl.: H03M 13/27, G06F 12/02, G06F 12/06, H04L 1/00

(54) **PARALLEL INTERLEAVER, PARALLEL DEINTERLEAVER, AND INTERLEAVE METHOD**

(30) Priority: 03.02.2005 JP 2005028314
(71) Applicant: MATSUSHITA ELECTRIC INDUSTRIAL CO., LTD., Osaka 571-8501 (JP)
(72) Inventor: MOTOZUKA, Hiroyuki, Matsushita Electric Industrial Co., Ltd., 2-1-61,Shiromi,Chuo-ku,Osaka-shi,Osaka 540-6207 (JP)
(74) Representative: Grünecker, Kinkeldey, Stockmair & Schwanhäusser Anwaltssozietät
(86) International application number: PCT/JP2006/301864
(87) International publication number: WO 2006/082923

(57) **Abstract**

There is provided a parallel interleaver having a comparatively simple structure and capable of flexibly coping with modification of an interleave pattern and preventing memory access concurrence. The parallel interleaver includes a memory (702) formed by a plurality of memory banks (RAM0 to RAM4), each of which is correlated to one or more row numbers in the two-dimensional arrangement, a pattern generation unit (710) for generating a plurality of in-row rearrangement patterns defined by other row in the data structure of two-dimensional arrangement, and read-out control units (706 to 712) having a pattern generation unit (710) inside for generating a plurality of addresses according to the plurality of in-row rearrangement patterns, so that a plurality of data are simultaneously read out from the memory (702).

## Description

### Technical Field

The present invention relates in particular to a parallel interleaver, parallel deinterleaver, and interleave method that implement an interleave algorithm that writes data on a row-direction priority basis to a rectangular matrix data structure, performs intra-row permutation for each row, permutes rows, and reads out data on a column-direction priority basis.

### Background Art

### (Interleave algorithm)

First, a conventional interleave algorithm will be described. Interleave processing permutes a K-length data sequence {d[0], d[1], ..., d[K-1]}, and outputs a data sequence {d'[0], d'[1], ..., d'[K-1]}. A data item d[i] may be one of various kinds of data, such as a single bit or a fixed-point number (a so-called soft decision value), and is hereinafter referred to as a symbol.

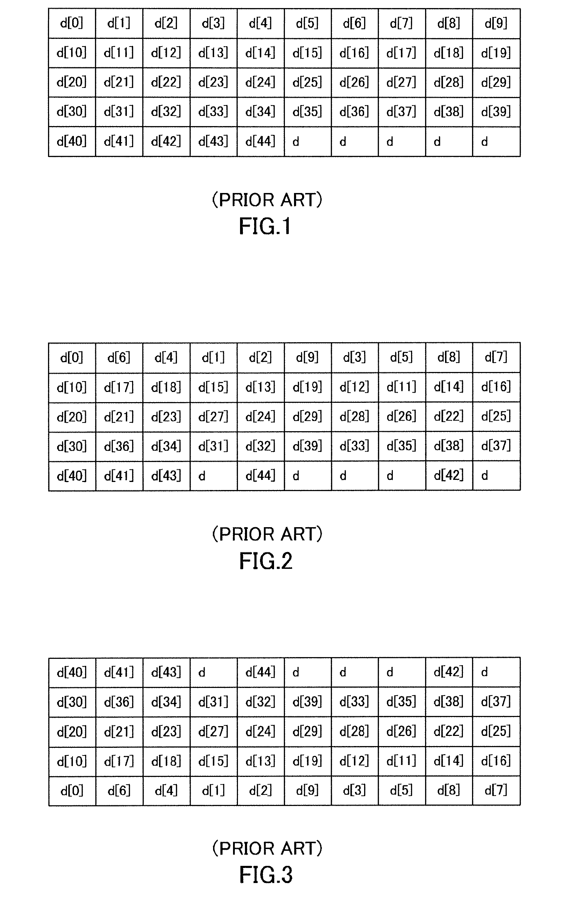

Conventional interleave algorithms include a type that uses a rectangular matrix data structure. This basic algorithm will now be described. The algorithm described in Non-patent Document 1 will be taken as an example. This interleave method is known as a Prime Interleaver (PIL). The PILprocedure is describedbelow. As an example, a case in which data length K = 45 will be described using FIG.1, FIG.2, and FIG.3.

Step 1: Number of rows R and number of columns C of an array are determined by means of a predetermined equation according to data length K.

Step 2: Symbols are written to the R-row, C-column array on a row-direction priority basis. At this time, if data length K is less than array size RC, dummy symbols (d) are written in the remaining area. This state is shown in FIG. 1.

Step 3: Next, intra-row permutation is performed for each row of the array in accordance with a predetermined rule. Here, the permutation rule may differ for each row. The permutation rule for each row is represented by the number sequence Ui(j). Ui(j) indicates the original intra-row position of data moved to row i, column j. For instance, in the example, U2 (3) = 7, indicating that the original position of data moved to row 2, column 3 is row 2, column 7. That is to say, d[27] is moved from row 2, column 7 to row 2, column 3 by intra-row permutation. This state is shown in FIG.2.

Step 4: Furthermore, while maintaining the order in each row, replacement is performed for each row in accordance with a predetermined rule. This inter-row permutation is represented by the number sequence T (i) . That is to say, the original position of a row moved to row i is row T(i). This state is shown in FIG.3.

Step 5: Lastly, data in the array is read out on a column-direction priority basis. At this time, dummy data is skipped ("pruned"). According to the above, the output symbol sequence becomes {d[40], d[30], d[20], d[10], ..., d[18], d[4], d[31], ..., d[16], d[7]}.

The method of determining R and C, intra-row permutation rule Ui(j), and inter-row permutation rule T (i) in the above procedure are stipulated in Non-patent Document 1. Numerous other methods have been proposed in addition to that shown in Patent Document 1.

The parallel interleaver proposed in the present invention is effective for all interleavers implemented by means of the above procedure, regardless of the R and C determination method, intra-row permutation rule Ui (j), and inter-row permutation rule T(i).

### (Interleaver implementation method)

When an interleaver circuit is actually implemented by means of an LSI or the like, rectangular matrix writing and intra-row/inter-row permutation such as described above are not performed. A generally known interleaver circuit writes symbols to memory in an orderly fashion in their order of input, and then performs permutation by reading them randomly. In the address calculation method used when this random memory reading is performed, interleaving such as described above is implemented by reversing the intra-row/inter-row permutation and row-direction priority read rules.

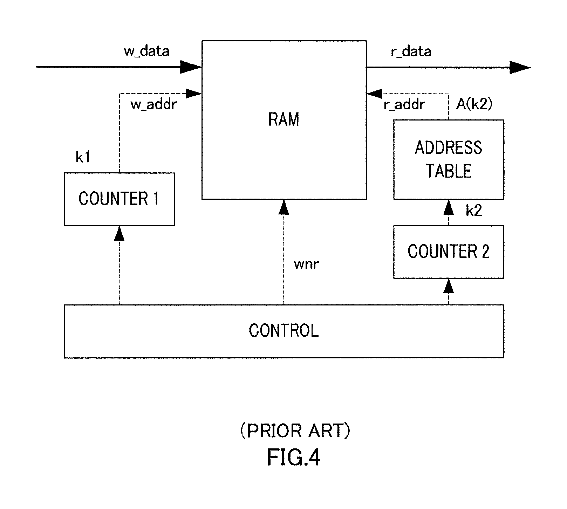

FIG.4 shows the most basic type of interleaver circuit. As this circuit processes one symbol per cycle, it is called a serial interleaver. A serial interleaver comprises RAM that stores a symbol sequence, a counter 1 that generates addresses in ascending order, and an address table and counter 2 that generate pseudorandom addresses.

Before interleave processing is performed, the address table is set in accordance with a rule that determines an interleave pattern. This procedure can be understood intuitively by reading FIG.3 column-wise.

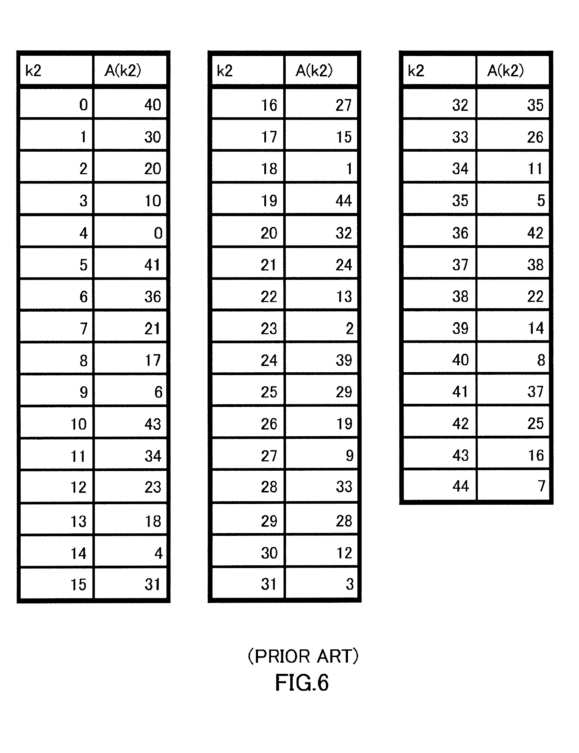

The address table in a PIL in which K = 45 is shown in FIG.6. This table shows, for example, that after permutation, the data to be output first is the 41st data prior to permutation - that is, A(0) = 40. (Note that the indices start from 0.) Also, the data output second is the 31st data prior to permutation.

Next, actual interleave processing will be described. Interleave processing is completed in two phases, writing and reading.

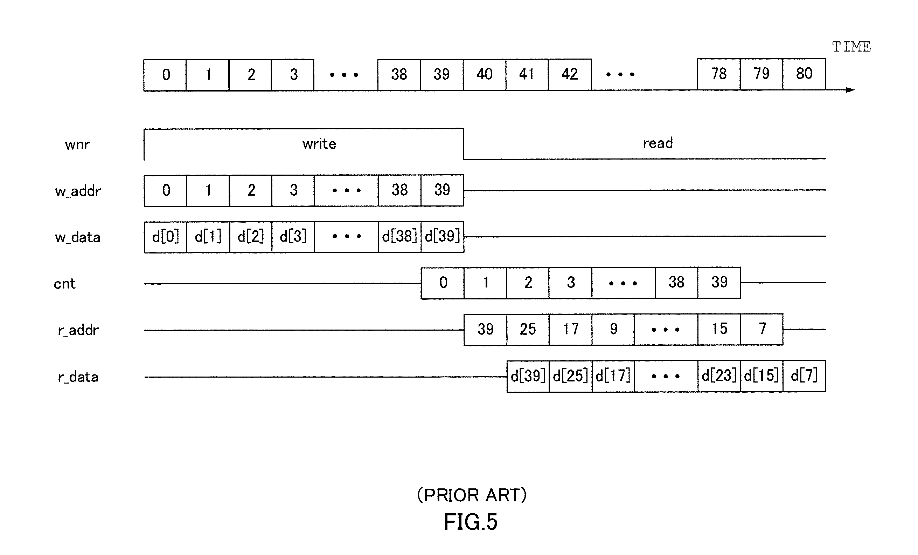

In the write phase, counter 1 generates addresses incremented by 1 at a time, starting from 0. A data sequence is stored in RAM in input order by writing input symbols to RAM using these addresses. Times 0 through 39 in the timing chart in FIG. 5 constitute the write phase.

After writing of all the symbols has been completed, a read operation starts. In the read phase, counter 2 first generates an ascending-order count value, and the address table is referenced using that count value as an address. Then one symbol is read from RAM using data (A (k2) ) output from the address table as an address. By repeating this kind of operation for each of the symbols, an interleaved data sequence can be obtained as shown by signal r_data in FIG.5.

Setting a pseudorandom address pattern in the address table beforehand in this way enables interleaving to be performed using any pattern. It is also possible to generate a pseudorandom address pattern without using an address table in memory. An example of an address generation circuit for a PIL is described in Patent Document 1.

Processing that restores an interleaved data sequence to its original order is called deinterleaving. Deinterleaving can also be implemented using the kind of serial interleaver shown in FIG.5. In this case, a deinterleave pattern is set in the address table.

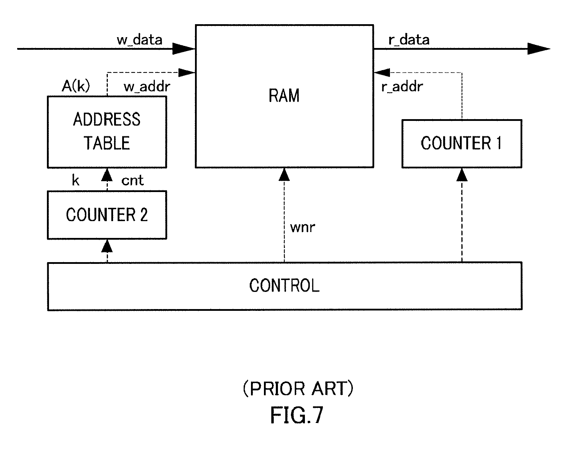

A simpler method of performing interleaving is to transpose serial interleaver write addresses and read addresses. The kind of configuration shown in FIG.7 may be used, for example. With this method, a circuit that performs interleaving and deinterleaving can be implemented by means of a minor circuit addition (a switch that transposes w_addr and r_addr), without preparing a new pattern.

### (Interleaver parallelization)

The interleaver in FIG.4 is of serial type - that is, a type that writes or reads one symbol in one cycle. Therefore, in order to interleave a data sequence comprising K symbols, a 2K+1 cycle delay is incurred between input of the first symbol and output of the last symbol. Also, the throughput (processing power per unit time) of a serial interleaver is low, at approximately 0.5 symbol/cycle.

Parallelization of interleaver circuitry is effective in implementing high-speed, low-delay interleave processing. Three interleave circuit parallelization methods will be described here.

### <Sub-block division method>

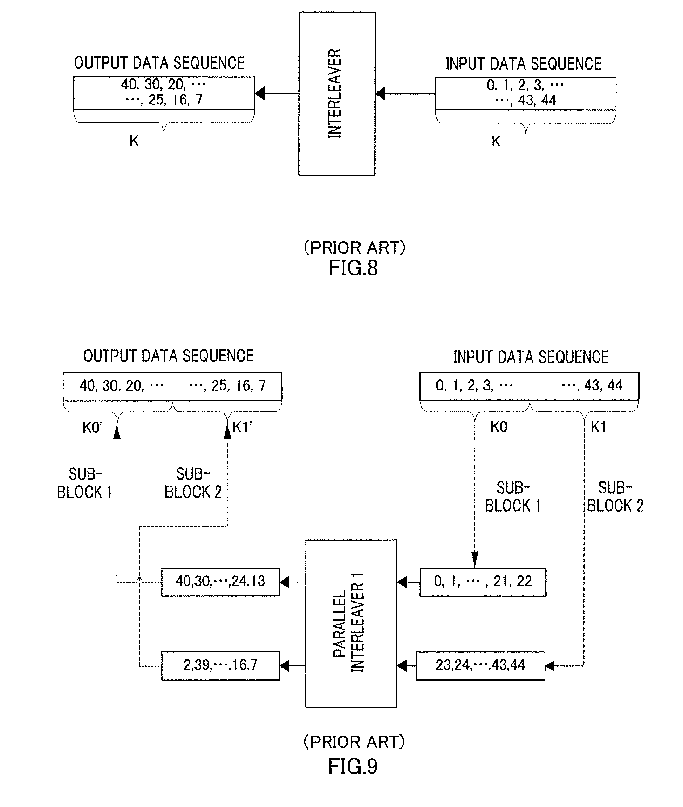

One method of parallelizing an interleaver is to divide an input data sequence into partial data sequences (sub-blocks) as shown in FIG.9. The sub-blocks are input to the interleaver in parallel.

In FIG.9, for example, a case is shown in which K = 45 and the number of sub-blocks is 2. In this example, data d[0] and d[23] are simultaneously input to a parallel interleaver 1 in the first cycle, and data d[1] and d[24] are simultaneously input in the next cycle. In the read phase, data d[40] and d[2] are simultaneously output. In this way, interleave processing can be completed with twice the throughput and half the delay time of the serial interleaver shown in FIG.8.

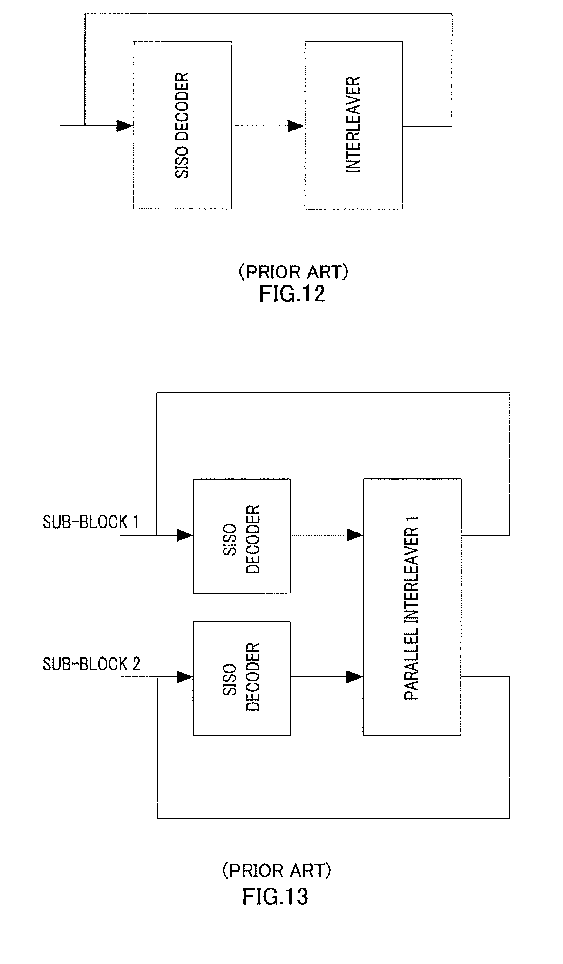

A turbo decoder configured using parallel interleaver 1 is shown in FIG.13. This turbo decoder is equipped with two SISO (Soft-In Soft-Out) decoders, enabling throughput to be doubled compared with the serial turbo decoder shown in FIG.12. This kind of parallel turbo decoder using sub-block division is described in Non-patent Document 2, for example.

### <Serial/parallel conversion method>

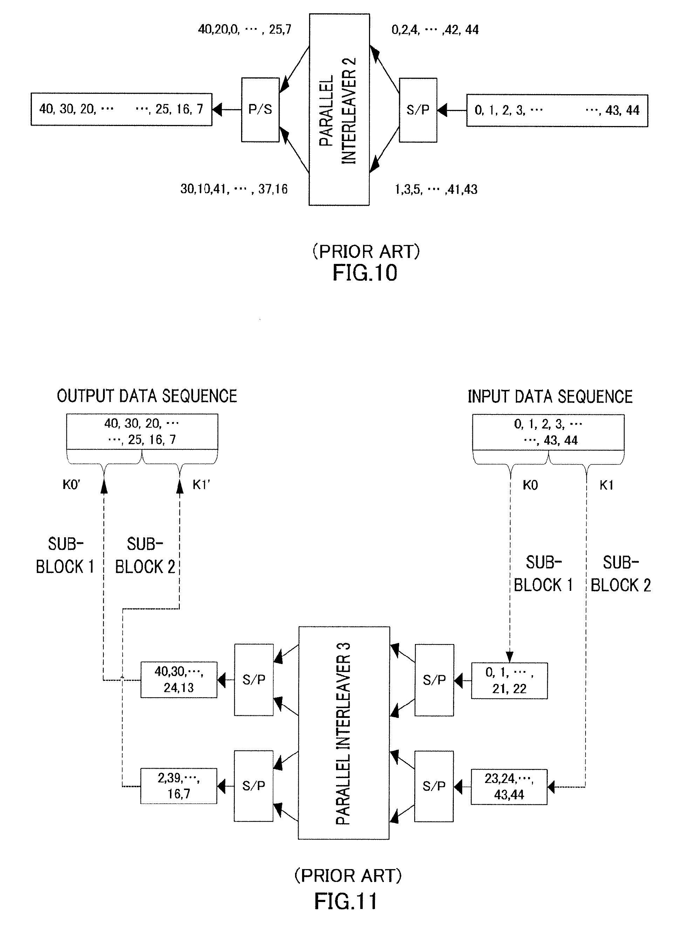

FIG.10 shows another parallel interleaver. With thismethod, consecutive data (for example, d[0] and d[1]) are simultaneously input to a parallel interleaver 2 by means of a serial/parallel converter ("S/P" in the figure). In the read phase, a pair of simultaneously output data are restored to a sequential data sequence by means of a parallel/serial converter ("P/S" in the figure).

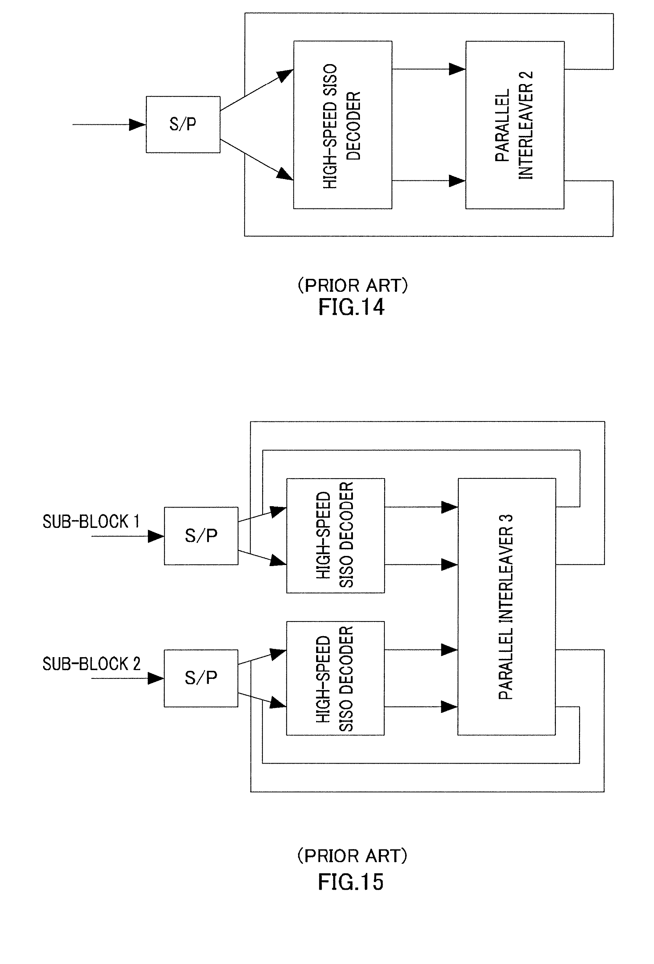

A turbo decoder configured using parallel interleaver 2 is as shown in FIG.14. In this type of parallel interleaver, simultaneously input data are consecutive in the data sequence, and so cannot be processed in parallel by separate SISO decoders. Therefore, a high-speed SISO decoder allowing simultaneous input of a plurality of data is necessary. An example of a known SISO decoder of this kind is the so-called radix-4 type described in Non-patent Document 3.

### <Hybrid method>

It is also possible to use a combination of a sub-block division method and a serial/parallel conversion method (radix-4).

A radix-4 type turbo decoder achieves throughput equivalent to that obtained by division into two parallel sub-blocks with a smaller circuit scale. However, it is difficult to further increase throughput (using radix-8 or above, for example) due to critical path and turbo code constraint length limitations.

Thus, a method can be envisaged whereby sub-block division is first performed with an arbitrary degree of parallelism, and each sub-block then undergoes radix-4 processing. Parallel interleaver 3 shown in FIG.11, designed in line with a turbo decoder having 2 as the number of sub-blocks and using radix-4 (FIG.15), has a degree of parallelism of 4 (= 2 × 2).

A problem with the above-described interleaver parallelization is the necessity of writing (reading) a plurality of data to (from) memory simultaneously. Examples of currently known solutions (implementation examples) are described below.

### (Parallelization implementation example 1)

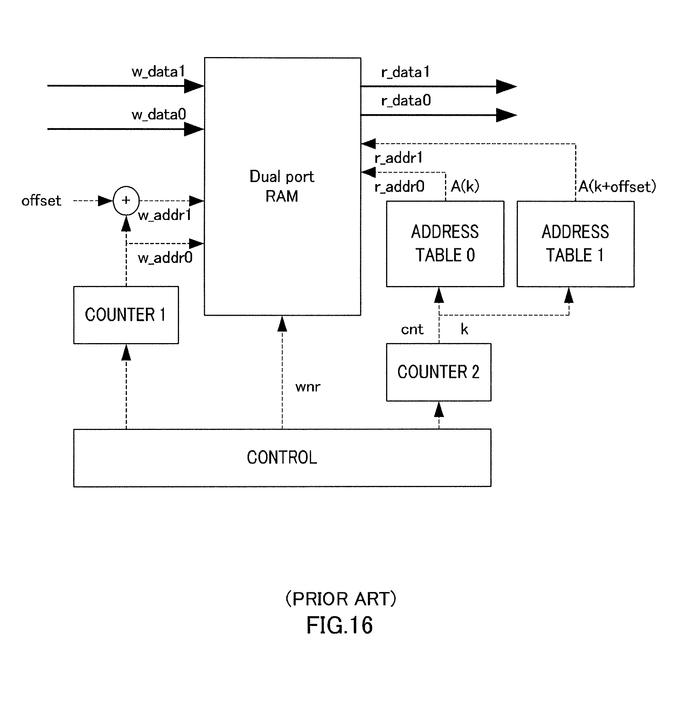

The simplest solution is to use multiport RAM. Multiport RAM enables simultaneous processing of a plurality of addresses, and simultaneous writing (reading) of a plurality of data. FIG. 16 shows a parallel interleaver that uses dual-port RAM (RAM allowing two simultaneous accesses). In FIG.16, the offset value should be set to the sub-block size in the case of a sub-block division type, or to 1 in the case of a serial/parallel conversion type.

### (Parallelization implementation example 2)

Another solution is to divide RAM into a plurality of banks (modules). As separate banks can be accessed independently, at a maximum the same number of accesses can be performed simultaneously as the number of memory banks.

However, depending on the interleave pattern and sub-block division method, two or more accesses may occur simultaneously for a particular bank (hereinafter referred to as "memory access contention"). Therefore, an arbitration circuit is necessary that, in the event of memory bank contention, enables one write to be performed in that cycle, and other data to be stored in a buffer and writing to be performed again from the next cycle onward.

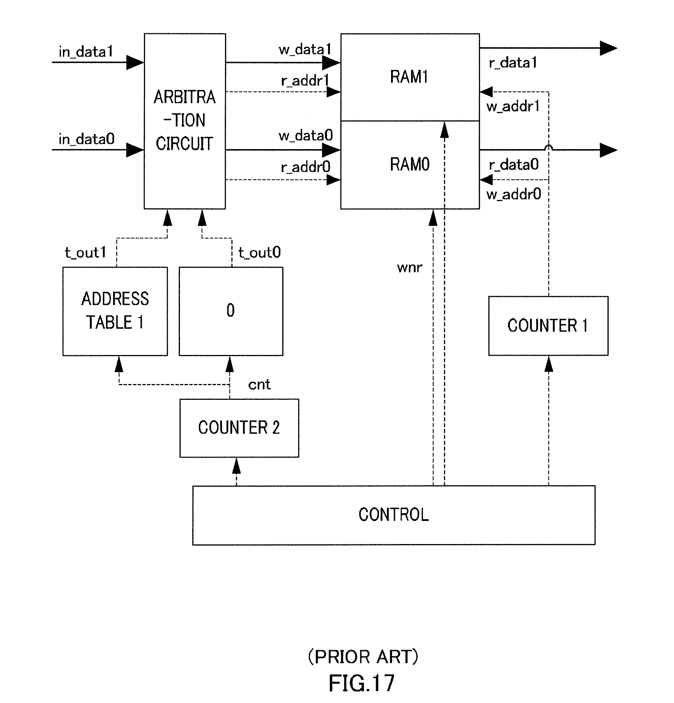

A method of avoiding memory access contention by means of an arbitration circuit will now be described using an example. Interleave processing will be considered for a case in which number of symbols K = 45, and sub-block division is performed almost equally so that K0 = 23 and K1 = 22. An example of the configuration of a parallel interleaver with an arbitration circuit is shown in FIG.17.

It is necessary for data output as sub-block 0 to be written to RAM0, and data output as sub-block 1 to be written to RAM1. Therefore, data with indices 0 through 22 after deinterleaving are written to RAM0, and data with indices 23 through 44 are written to RAM1.

In the first cycle of the write phase, data d[0] and d[23] at the head of the two sub-blocks are input. Addresses are found as A(0) = 40 from address table 0 and A (23) = 0 from address table 1, indicating that data d[0] should be written to RAM1, and data d[23] to RAM0. Therefore, the arbitration circuit performs connections so that the signal in data0 value is input to w_data1, and the signal in_datal value is input tow_data0. Also address table 1 output is input to w_addr0, and a value obtained by decrementing address table 0 output by 23 is input to w_addr1.

In the next cycle, data d[1] and d[24] are input. Since A (1) = 30 and A (24) = 39, it is necessary for both data to be written to RAM1 . Thus, data d[1] is written to address 7 of RAM1, while d[24] is stored in a buffer (such as a FIFO buffer, for example), and is written from the next cycle onward.

Then, in the next cycle, data d[2] and d[25] are input. In this cycle, data d[2] is written to address 20 of RAM0, and data d[24] is read out from the buffer and written to address 16 of RAM1. As only one write to RAM1 can be performed at a time, this time data d[25] is stored in the buffer.

By using an arbitration circuit in this way, it is possible to implement a parallel interleaver circuit without using dual-port memory. Another advantage of this method is that the total RAM capacity need not be increased.

However, the greater the randomness of an interleave pattern, the larger is the buffer capacity needed for the arbitration circuit.

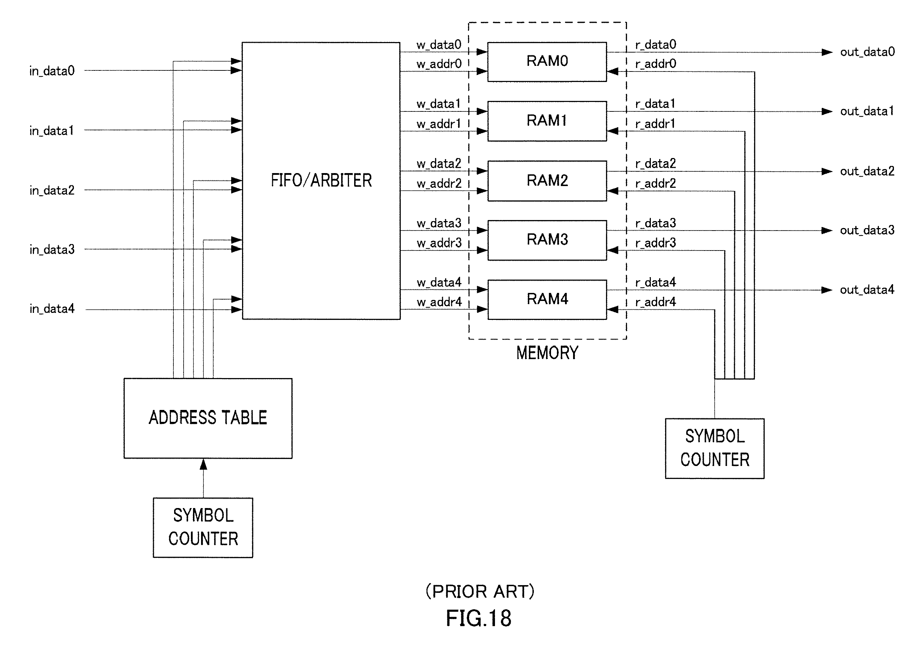

Another example of a configuration for a case in which RAM is divided into a plurality of banks (modules) in this way is shown in FIG.18.

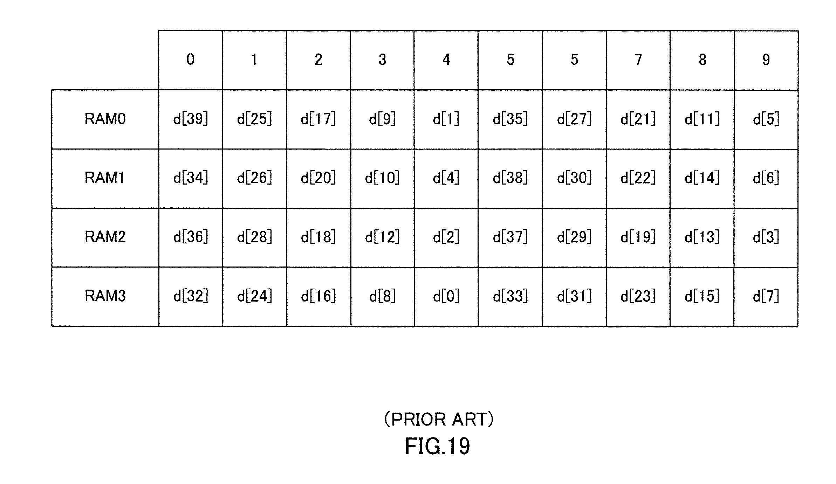

In the interleaver (deinterleaver) in FIG.18, one output sub-block is associated with one RAM bank. For example, data belonging to output sub-block 0 is written to RAM0. The method of writing to memory when K = 40, for example, is illustrated in FIG. 19. After writing has been performed in this way, four sub-blocks can be output in parallel by reading the respective RAM contents in address order.

As input data is divided into sub-blocks, it is also necessary for writes to be performed in parallel. For example, in cycle 0 it is necessary for data d[0], d[10], d[20], and d[30] to be written simultaneously. At this time, data d[10], d[20] and d[30] must all three be written to RAM1. However, since RAM1 is single-port memory, only one of these data can be written. Thus, in cycle 0, only data d[10] is written to RAM1, and data d[20] and d[30] are stored in a buffer (FIFO buffer), and written to RAM1 one at a time from the next cycle onward. The circuit that performs this kind of arbitration and buffering is the FIFO/arbiter section in the figure.

As with the configuration in FIG.18, a parallel interleaver can be implemented by dividing memory into the same number of memory banks (RAM0 through RAM4) as the number of sub-blocks. This kind of configuration is described in Patent Document 2, for example.

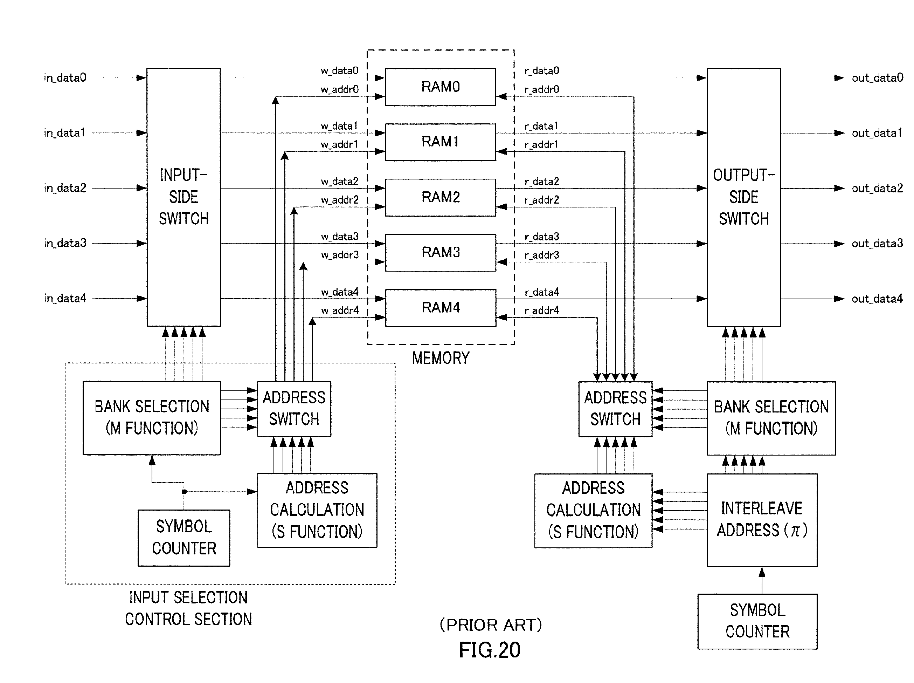

An example of a configuration whereby memory access contention is avoided by means of a bank assignment (data write location) scheme is shown in FIG.20. In the interleaver in FIG.20, a data write location is determined by a function M of a bank selection section. Input data d[i] (where i = 0 to K-1) is written to bank M (i). When the sub-block size is designated Ks, data d[i], d[i+Ks], d [i+2Ks], ... are written simultaneously, and therefore the condition M(i) ≠ M(i+Ks) ≠ M(i+2Ks) ≠ ... is necessary in order to prevent the occurrence of access contention. Also, when the interleave pattern is designated n, output data d[n(i)], d[π(i+Ks)], d[π(i+2Ks)], ... are read out simultaneously. Therefore, it is necessary to satisfy the condition M(π(i)) ≠ M(π ( i+Ks)) ≠ M (π(i+2Ks) ) ≠ ... in order to prevent the occurrence of access contention when reading. Finding this kind of function M enables parallel interleaving to be implemented by the kind of circuit shown in FIG.20.

Non-patent Document 4 describes a design method for function M for any interleave pattern n.

A technology for performing interleaving by means of the same kind of circuit configuration as in FIG.20 is described in Patent Document 3. In Patent Document 3, the M function is a simple function (such as an integer division, for example). In Patent Document 3, it is proposed that an M function and interleave pattern n be selected so that M(π(i)), M(π(i+Ks)), M(π(i+2Ks)), ... have a fixed relationship. For example, an example of an M function and an interleave pattern n are shown such that M(π(i+Ks)) - M(π(i)) = M(π(i+2Ks)) - M(π(i+Ks)) = ... = a constant value. At this time, non-occurrence of memory access contention can be guaranteed according to the relationship between the above constant value and the number of banks (for example, the constant value and number of banks are relative prime). In Patent Document 3, an interleave pattern n design method that always satisfies the above relationship is disclosed, making it possible to design an interleave pattern n that allows parallel processing by the circuit in FIG.20 without causing memory access contention.
Patent Document 1: Japanese Patent No.3399904
Patent Document 2: Unexamined Japanese Patent Publication No.2004-104776
Patent Document 3: United States Patent No.6,775,800
Non-patent Document 1: 3GPP TS25.212 v5.4.0 "Multiplexing and channel coding (FDD), Release5" section 4.2.3.2.3 Turbo code internal interleaver
Non-patent Document 2: Giulietti, A.; Bougard, B.; Derudder, V.; Dupont, S.; Weijers, J.-W.; Van der Perre, L.; "A 80Mb/s low-power scalable turbo codec core", Custom Integrated Circuits Conference, 2002. Proceedings of the IEEE 2002, pp. 389-392
Non-patent Document 3: Charles Thomas, Mark A. Bickerstaff, Linda M. Davis, Thomas Prokop, Ben Widdup, Gongyu Zhou, David Garrett, Chris Nicol; "Integrated Circuits for Channel Coding in 3G Cellular Mobile Wireless Systems", IEEE Communications Magazine August 2003, pp.150-159
Non-patent Document 4: Tarable, A.; Benedetto, S.; "Mapping interleaving laws to parallel turbo decoder architectures", Communications Letters, IEEE, Volume: 8, Issue: 3, March 2004, Pages:162 - 164

### Disclosure of Invention

### Problems to be Solved by the Invention

However, multiport RAM has a large circuit scale, and is seldom used. Dual-port RAM is often used in FPGAs (Field Programmable Gate Arrays), making it possible to implement an interleaver with dual-parallelism, but it is difficult to implement an interleaver with a higher degree of parallelism.

A drawback of the method described in Patent Document 2 is the complexity of the arbitration function. As the number of sub-blocks (degree of parallelism) increases, the arbitration function becomes more complex, leading to an increase in the circuit scale. Another drawback is the length of the FIFO buffer. The need for a long FIFO buffer results in an increased circuit scale and long delay times.

With the M function design method shown in Non-patent Document 4, the M function cannot be represented by a simple equation, making table lookup necessary for its implementation. It is therefore necessary to add comparatively large memory, increasing the interleaver circuit scale. Also, it is necessary to change the M function each time the interleave pattern changes, but deriving an M function in real time is considered to be difficult in practical terms. It is therefore difficult to cope with a case in which the interleave pattern changes each time the data length changes, as with a 3GPP-standard turbo coding internal interleaver.

With regard to Patent Document 3, it is difficult to find an M that satisfies the above equation for a particular given n. Also, a method of doing so is not considered in Patent Document 3. The technology described in Patent Document 3 can be said to be no more than a design method for π that satisfies the above equation, and a method of performing parallel interleaving for a particular π. There is thus a problem in that it is difficult to parallelize a turbo internal interleaver depicted in the 3GPP standard without memory access contention even with the use of the technology described in Patent Document 3.

It is therefore an object of the present invention to provide a parallel interleaver, parallel deinterleaver, and interleave method that enable interleave pattern changes to be coped with flexibly, and memory access contention to be avoided, with a comparatively simple configuration.

### Means for Solving the Problems

A parallel interleaver of the present invention implements an interleave algorithm by writing input data to memory composed of a plurality of memory banks and reading out written data in an order different from the write order, the algorithm writing data on a row-direction priority basis to a rectangular matrix data structure, performing intra-row permutation based on an intra-row permutation pattern stipulated for each row, permuting rows, and reading out data on a column-direction priority basis, wherein the interleaver employs a configuration that includes: a memory composed of a plurality of memory banks, each bank being associated with one or a plurality of row numbers of the rectangular matrix; a pattern generation section that generates a plurality of intra-row permutation patterns stipulated in another row in the rectangular matrix data structure; and a read control section that has the pattern generation section inside and generates a plurality of read addresses based on the plurality of intra-row permutation patterns; and whereby a plurality of data are read out simultaneously from the memory.

### Advantageous Effect of the Invention

According to the present invention, two or more read addresses are not generated in the same memory bank no matter what kinds of intra-row and inter-row permutation patterns are used. That is to say, memory bank memory access contention can be avoided no matter what kind of interleave pattern is used. As a result, a parallel interleaver, parallel deinterleaver, and interleave method can be implemented that enable interleave pattern changes to be coped with flexibly, and memory access contention to be avoided, with a comparatively simple configuration.

### Brief Description of Drawings

FIG.1 is a drawing showing a 2-dimensional matrix of a prime interleaver after writing the data set;
FIG.2 is a drawing showing a 2-dimensional matrix of a prime interleaver after intra-row permutation;
FIG.3 is a drawing showing a 2-dimensional matrix of a prime interleaver after inter-row permutation;
FIG.4 is a block diagram showing the configuration of a serial interleaver;
FIG.5 is a timing chart showing the operation of the serial interleaver in FIG.4;
FIG. 6 is a drawing showing the contents of the address table in FIG.4;
FIG.7 is a block diagram showing an example of the configuration of a deinterleaver corresponding to a serial interleaver;
FIG.8 is an explanatory schematic diagram illustrating serial interleaving operation;
FIG.9 is an explanatory schematic diagram illustrating sub-block division interleaving (parallel interleaver) operation;
FIG.10 is an explanatory schematic diagram illustrating another parallel interleaver;
FIG.11 is an explanatory schematic diagram illustrating another parallel interleaver;
FIG.12 is a block diagram showing an example of the configuration of a turbo decoder that uses a serial interleaver;
FIG. 13 is a block diagram showing an example of the configuration of a turbo decoder that uses the parallel interleaver in FIG.9;
FIG.14 is a block diagram showing an example of the configuration of a turbo decoder that uses the parallel interleaver in FIG.10;
FIG.15 is a block diagram showing an example of the configuration of a turbo decoder that uses the parallel interleaver in FIG.11;
FIG.16 is a block diagram showing the configuration of a conventional parallel interleaver that uses dual-port RAM;
FIG.17 is a block diagram showing an example of the configuration of a parallel interleaver that has a conventional arbitration circuit;
FIG.18 is a block diagram showing another example of the configuration of a parallel interleaver (deinterleaver) in a conventional case in which RAM is divided into a plurality of banks (modules);
FIG.19 is a drawing showing data written to RAM0 through RAM4 in FIG.18;
FIG.20 is a block diagram showing another example of the configuration of a parallel interleaver (deinterleaver) in a conventional case in which RAM is divided into a plurality of banks (modules);
FIG.21 is a block diagram showing the configuration of an interleaver according to Embodiment 1 of the present invention;
FIG.22 is a drawing showing the contents of lookup tables LUT0 through LUT4;
FIG.23 is a drawing showing the data arrangement in RAM after all data has been written;
FIG.24 is a timing chart showing write timing in Embodiment 1;
FIG.25 is a timing chart showing read timing in Embodiment 1;
FIG.26 is a drawing showing the contents of lookup tables LUT0 through LUT4 when invalid addresses are included;
FIG.27 is a drawing showing the contents of improved lookup tables LUT0 through LUT4 when invalid addresses are included;
FIG.28 is a timing chart showing write timing when pruning occurs;
FIG.29 is a timing chart showing read timing when pruning occurs;
FIG.30 is a drawing showing output block sizes when pruning occurs;
FIG.31 is a block diagram showing the configuration of an interleaver of Embodiment 2;
FIG.32 is a block diagram showing the configuration of an invalidity determination section;
FIG.33 is a drawing showing the contents of lookup tables LUT0 through LUT4 in Embodiment 2;
FIG.34 is a timing chart showing write timing in Embodiment 2;
FIG.35 is a timing chart showing read timing in Embodiment 2;
FIG.36 is a block diagram showing another example of the configuration of an interleaver of Embodiment 2;
FIG.37 is a drawing showing the contents of lookup tables LUT0 through LUT4 in the interleaver in FIG.36;
FIG.38 is a timing chart showing write timing in the interleaver in FIG.36;
FIG.39 is a timing chart showing read timing in the interleaver in FIG.36;
FIG.40 is a block diagram showing an example of the configuration of a turbo decoder of Embodiment 3;
FIG.41 is a block diagram showing an example of the configuration of a turbo decoder of Embodiment 3;
FIG.42 is a block diagram showing an example of the configuration of a turbo decoder of Embodiment 3;
FIG.43 is a block diagram showing the configuration of an interleaver of Embodiment 4;
FIG.44 is a drawing showing write-time combinations and read-time combinations;
FIG.45 is an explanatory drawing illustrating bank assignment;
FIG.46 is an explanatory drawing illustrating bank assignment;
FIG.47 is a drawing showing input-side switch configurations;
FIG.48 is a drawing showing column number switch configurations;
FIG.49 (A) is a drawing illustrating input data sub-block division, and FIG.49 (B) is a drawing illustrating output data sub-block division;
FIG.50 is a drawing showing the row counter initial value, column counter initial value, and first-data ranking for each sub-block;
FIG.51 is an explanatory drawing illustrating the column number switch function;
FIG.52 is a block diagram showing the configuration of a pruning determination section;

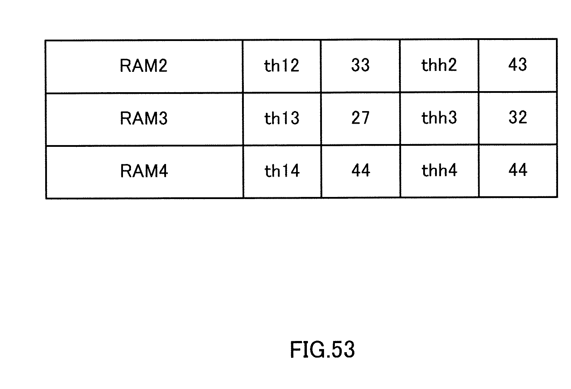

FIG.53 is a drawing showing examples of threshold values;
FIG.54 is a block diagram showing the configuration of an interleaver of Embodiment 5;
FIG.55 is a drawing showing input-side switch configurations;
FIG.56 (A) is a drawing illustrating input data sub-block division, and FIG.56 (B) is a drawing illustrating output data sub-block division;
FIG.57 is a drawing showing write-time combinations and read-time combinations;
FIG.58 is an explanatory drawing illustrating bank assignment;

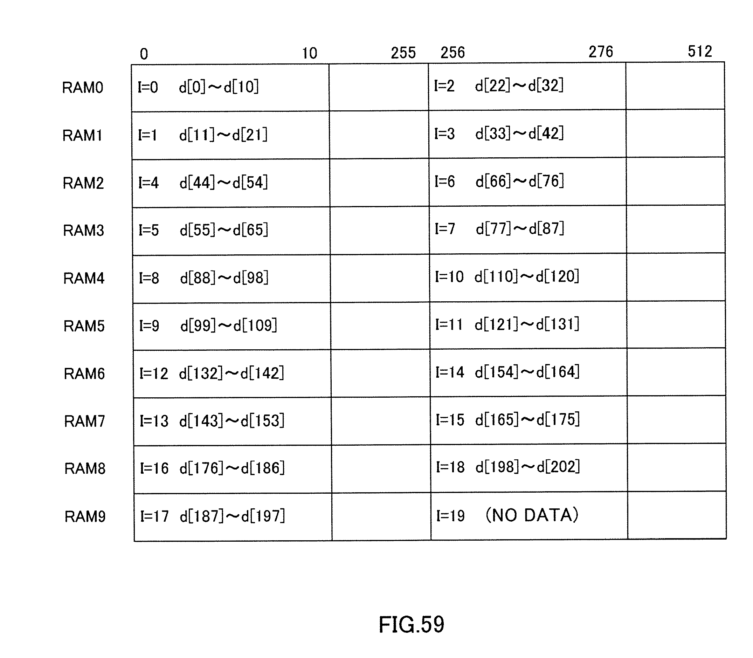

FIG.59 is an explanatory drawing illustrating bank assignment;
FIG.60 is a drawing showing the input/output order, row counter initial value, column counter initial value, and first-data ranking for each sub-block;
FIG.61 is an explanatory drawing illustrating the column number switch function;
FIG.62 is a drawing showing column number switch configurations;
FIG. 63 is a block diagram showing the configuration of an interleaver of Embodiment 6;
FIG.64 is a drawing illustrating output data sub-block division;
FIG.65 is a drawing showing write-time combinations and read-time combinations;
FIG.66 is an explanatory drawing illustrating bank assignment;
FIG.67 is a drawing showing column number switch configurations;
FIG.68 is a drawing showing input-side switch configurations;
FIG.69 is a drawing showing another example of the configuration of row counters, column counters, and a column number switch;
FIG.70 is an explanatory drawing illustrating an example of the configuration of a transfer circuit;
FIG.71 is a block diagram showing an example of the configuration of a parallel turbo decoder corresponding to an interleaver of Embodiment 4; and
FIG.72 is a block diagram showing an example of the configuration of a parallel turbo decoder corresponding to an interleaver of Embodiment 6.

### Best Mode for Carrying Out the Invention

Embodiments of the present invention will now be described in detail with reference to the accompanying drawings.

### (Embodiment 1)

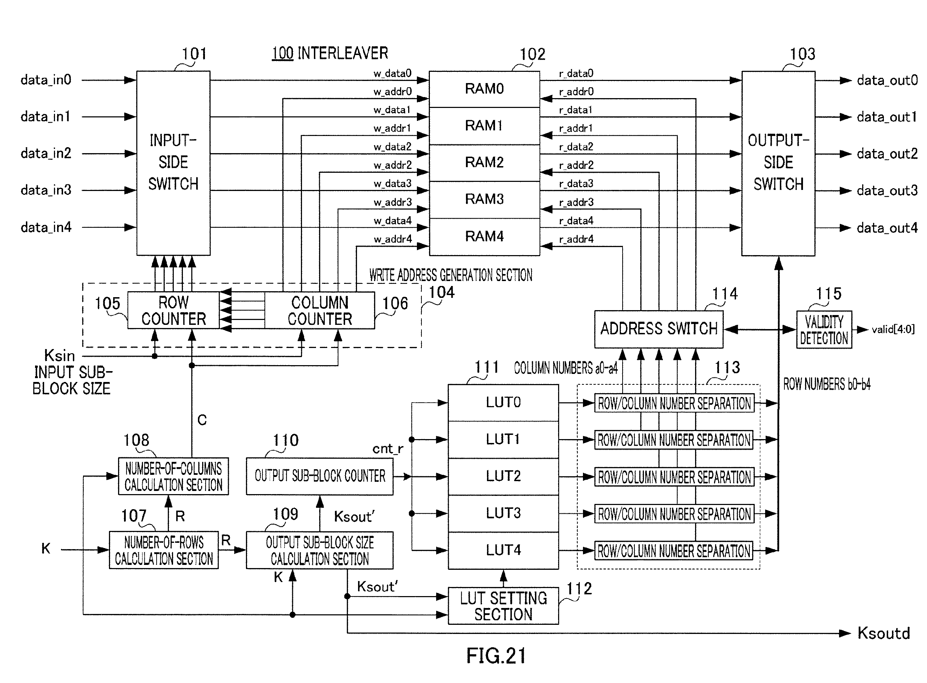

FIG.21 shows the configuration of an interleaver according to Embodiment 1 of the present invention. This interleaver 100 can execute PIL (prime interleaving) in parallel without causing memory access contention. To simplify the explanation, in this embodiment circuitry corresponding to a case in which interleaver number of rows R = 5 only is shown, and the basic configuration is described.

Interleaver 100 is a circuit that performs interleaving with 5-fold parallelism by means of sub-block division. First, for simplicity, a case in which pruning does not occur (data length K = RC) will be described.

Interleaver 100 broadly comprises an input-side switch 101, memory 102 comprising a plurality of independently writable and readable banks (RAM0 through RAM4), an output-side switch 103, a write address generation section 104 comprising a row counter 105 and column counter 106, a number-of-rows calculation section 107, a number-of-columns calculation section 108, an output sub-block size calculation section 109, an output sub-block counter 110, an address table 111 comprising lookup tables LUT0 through LUT4, a lookup table (LUT) setting section 112, a row/column number separation circuit 113, an address switch 114, and a validity detection section 115.

Number-of-rows calculation section 107 and number-of-columns calculation section 108 determine number of rows R and number of columns C based on number of symbols K in accordance with the 3GPP standard.

Input data data_in0 through data_in4 are input after being divided into sub-blocks by a preceding-stage processing block (de-rate-matching processing, SISO (Soft-In Soft-Out) decoding processing, or the like, for example). Input sub-block 0 (corresponding to data_in0) through input sub-block 3 are all of equal size. This is expressed as Ksin. In order to prevent the occurrence of write contention in an interleaver circuit of the present invention, it is necessary for input sub-block size Ksin to be greater than or equal to number of columns C.

Input sub-block size Ksin is provided from outside. Based on the provided input sub-block size Ksin, interleaver 100 sets the initial values of column counter 106 and row counter 105 in write address generation section 104. The initial value setting method will be described together with a write operation.

Output sub-block size calculation section 109 determines output sub-block size Ksout' from number of symbols K and number of rows R. When number of output sub-blocks Mout is equal to number of RAMs Mr and number of rows R, as in the basic circuit in FIG.21, output sub-block size Ksout is set so as to be relative prime with respect to number of rows R (having a greatest common divisor of 1). Of course, designating the number of sub-blocks as Ms, it is necessary for output sub-block size Ksout to satisfy the relationship Ksout × Ms ≥ RC. (Here, K = RC. The reason for not writing K on the right-hand side is to provide for a case in which pruning is used.)

One method of setting output sub-block size Ksout is to find a value that is relative prime with respect to R in order, such as Ksout = C, C+1, C+2, ....

Another method is to set Ksout by means of the following equation.

$Ksout = ceiling ( ( c - floor \left(Ro\times Ms/R\right) ) / Ms ) \times R + Ro$
where:
ceiling() indicates rounding toward infinity (round-up processing),
floor() indicates rounding toward zero (round-down processing),
Ro indicates a constant relative prime with respect to R (for example, 1), and
Ms indicates the number of sub-blocks.

After output sub-block size Ksout' is determined, lookup table (LUT) setting section 112 performs setting of five lookup tables LUT0 through LUT4 of address table 111. The five lookup tables LUT0 through LUT4 correspond respectively to the five sub-blocks. LUT0 through LUT4 are set so that when a counter value cnt_r is input as an address, a bank number b and address (memory bank internal physical address) a are output. Here, bank number b corresponds to a row number after inter-row permutation in the interleaving procedure, and address a corresponds to a column number after inter-row permutation in the interleaving procedure. The relationship between bank number b, address a, and interleave address A(k2) is as shown by the following equations.

$\begin{matrix}b [ m ] = floor \left\{A⁢\left(cnt_r+m\times C\right)/C\right\} \\ a \left[m\right] = A ⁢ \left({cnt}_{-}⁢r+m\times C\right) mod C\end{matrix}$
where: $m = 0 , 1 , ⋯ , Mout - 1 ,$
floor indicates rounding toward zero (round-down processing), and
mod indicates a remainder operation.

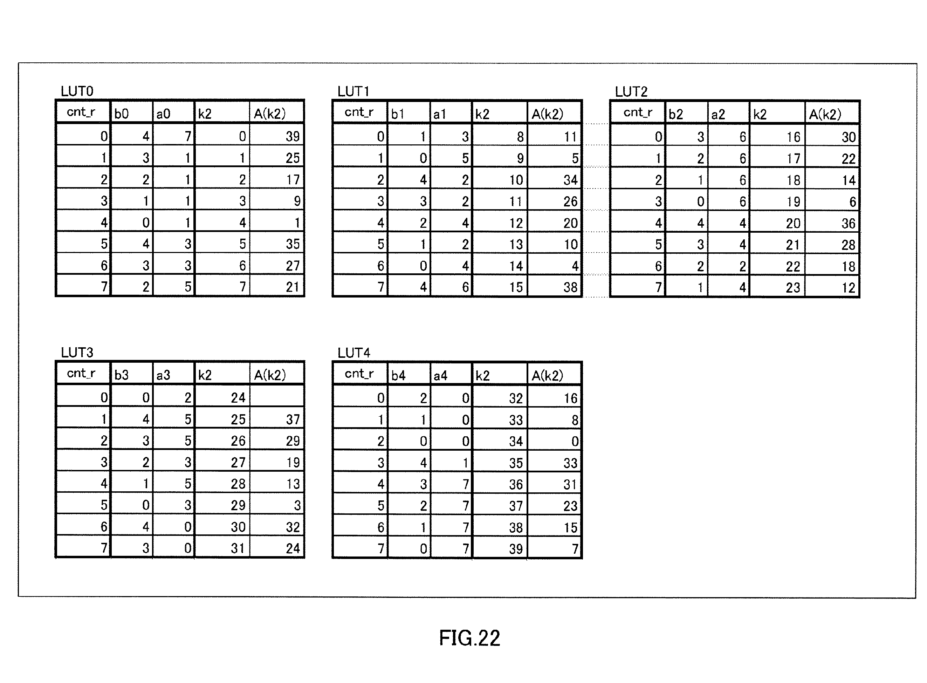

An example of a created address table 111 (lookup tables LUT0 through LUT4) is shown in FIG.22. Although k2 and A(k2) are also included here for reference, the only values actually held in LUT0 through LUT4 are bank number b and address a. This example shows a case in which data length K = 40 and output sub-block size Ksout = 8. Referring to the cnt_r = 2 entry in LUT2, for example, it can be seen that data with a post-interleaving index of 18 (and a pre-interleaving index of 14) is written to address 6 of RAM1.

After the above-described initial settings have been completed, parallel interleaving is executed by means of a write phase and a read phase.

In this embodiment, input data data_in0 through data_in4 are separated in C units and written to separate banks (RAM0 through RAM4). For example, in the basic circuit in FIG.21, the n'th input symbol is written to the floor(n/C)'th bank. At this time, the physical address (read address input to the relevant bank) is n mod C (where mod is a remainder operation).

Interleaver 100 of this embodiment uses row counter 105 and column counter 106 to implement the kind of write processing described above. Row counter 105 and column counter 106 each have a plurality of internal counters. Here, counter values are designated i [k] and j [b] , where k= 0 to Ms-1 (Ms being the number of sub-blocks) , and b = 0 to Mr-1 (Mr being the number of RAM banks).

Counter initial values i0[k] and j0[b] are determined by means of the following equations using input sub-block size Ksin.

$\begin{matrix}i 0 \left[k\right] = floor \left(Ksin\times k/C\right) \\ j 0 [ i 0 \left[k\right] ] = \left(Ksin\times k\right) mod C \\ j 0 \left[b\right] = C \left(when there is no k for which b=i 0\left[k\right]\right)\end{matrix}$

In the write phase, column counter j[k] is incremented by 1 each cycle starting from its initial value, and counts up to number of columns C. When number of columns C is reached, column counter j [k] stops, but corresponding row counter i[k] is incremented, and counter j[i[k]] is reset.

The above processing will be described using an example. It is assumed here that sub-block size Ks is greater than C. When writing starts, i[0] = 0 and j [0] = 0, and therefore sub-block 0 input (data_in0) is written to address 0 of RAM0 . Thereafter, for C-1 cycles, sub-block 0 data is written to addresses 0 through C-1 of RAM0.

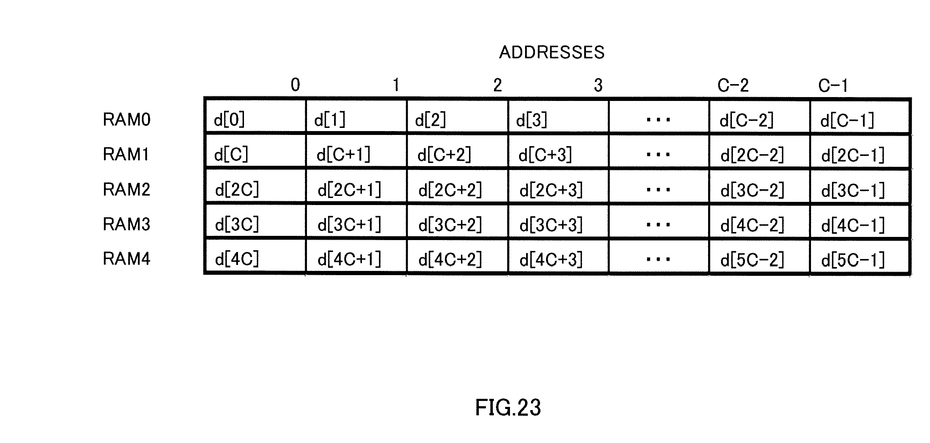

At this time, j[0] = C-1, and therefore in the next cycle i[0] is incremented so that i [0] = 1, counter j[i[0]] is reset, and operation is started. That is to say, j [1] = 0. Therefore, at this point in time, the C' th data of sub-block 0 is written to address 0 of RAM1 . FIG.23 shows the data arrangement in RAM0 through RAM4 after all data has been written.

In the read phase, output sub-block counter 110 performs an up-count from 0 to output sub-block size Ksout-1, and counter value cnt_r is input to LUT0 through LUT4 as an address. LUT0 through LUT4 output the bank number and address of data that should be read at that point in time. For example, In the example shown in FIG.22, when counter value cnt_r = 0, LUT0 outputs b0 = 4 and a0 = 7. This indicates that address 7 of bank 4 should be read in order to output the first data (d[39]) of sub-block 0.

The five outputs from LUT0 through LUT4 are input to row/column number separation circuit 113, and each separated into a row number b and column number a.

Column numbers a0 through a4 are input to address switch 114, and distributed to the memory banks (RAM0 through RAM4) specified by row numbers b0 through b4. For instance, in the above example, the LUT0 output a0 = 7 address is transferred to RAM4 since b0 = 4, and LUT1 output a1 = 3 is transferred to RAM1 since b1 = 1. Thus, row numbers b0 through b4 control address switch 114 so that column numbers a0 through a4 are transferred to the appropriate RAM modules.

Row numbers b0 through b4 also control output-side switch 103 so that RAM0 through RAM4 outputs are distributed to the appropriate output data signals data_out0 through data_out4. For instance, in the above example, since LUT0 output b0 = 4, the data to be output to data_out0 is known to be output from RAM4. Therefore, output-side switch 103 connects signal r_data4 to signal data_out0.

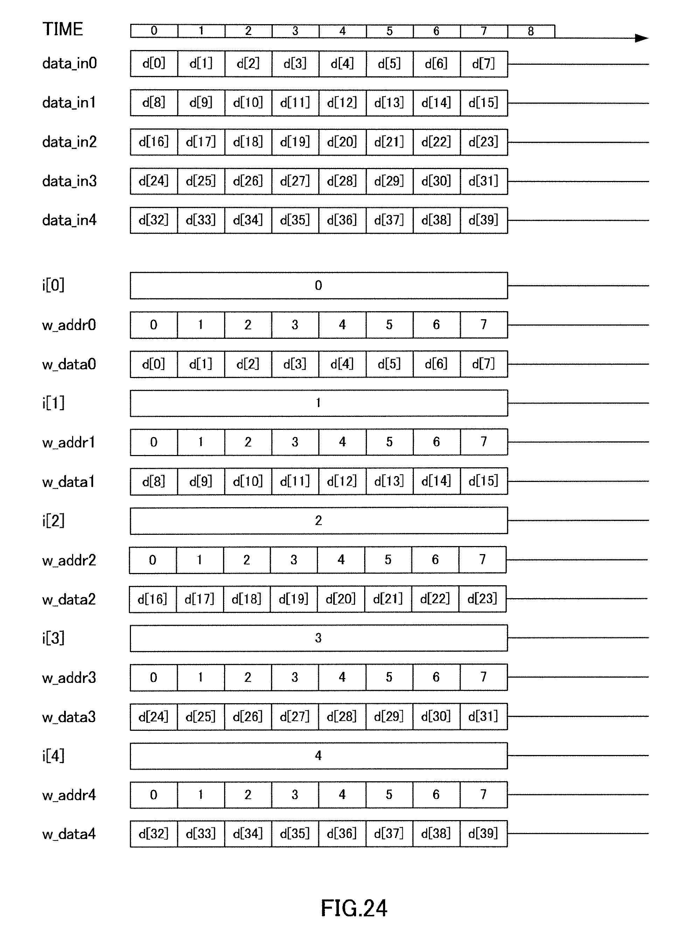

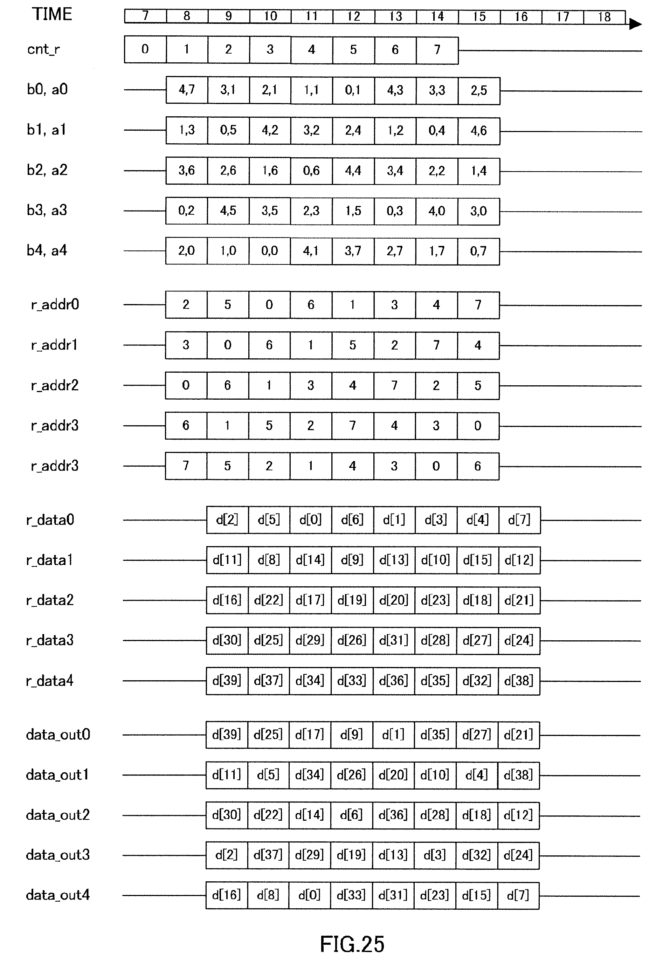

In this way, parallel interleaving can be implemented by means of division into five sub-blocks. The above operations are shown again as timing charts in FIG.24 and FIG.25. FIG.24 shows write timing, and FIG.25 shows read timing.

There are two main points for preventing the occurrence of memory contention in interleaver 100 of this embodiment, as follows.

(i) In a 2-dimensional matrix for generating an interleave pattern, symbols corresponding to different rows are written to different memory banks RAM0 through RAM4.
(ii) Output sub-block size Ks is selected so as to be relative prime with respect to number of rows R.

Here, condition (ii) can be rephrased as follows: "With regard to two or more simultaneously read symbols, simultaneously read symbols are selected so that, for any two, positional spacing S is relative prime with respect to number of rows R."

If this condition is applied, it can be seen that, even with a serial/parallel conversion type of parallel interleaver, as long as the degree of parallelism is less than or equal to R, it is possible to design an interleaver capable of parallel reading without causing memory access contention.

Next, pruning processing by interleaver 100 of this embodiment will be described.

It is possible for interleaver 100 to perform parallel execution of interleave processing without causing memory access contention even when pruning occurs (when K<RC).

There are two main points for handling pruning, as follows:
(i) LUT0 through LUT4 are created including a symbol subject to pruning (invalid address).
(ii) In a part corresponding to an invalid address, a symbol is not output for that sub-block only.

A case in which K = 45 is described below as an example.

Number-of-columns calculation section 108 and number-of-rows calculation section 107 find number of rows R = 5 and number of columns C = 10 in accordance with the 3GPP standard.

Conditions for the input sub-block size are the same as when pruning does not occur. However, when number of banks Mr and number of sub-blocks Ms are the same, as in this example, the condition Ksin≥C means that the last sub-block is always shorter than C (Ksin is the size of sub-blocks other than the last). Conversely, if sub-block division is performed so that all sub-blocks are of equal size, write-time contention is sure to occur.

Output sub-block size calculation section 109 sets output sub-block size Ksout so as to be relative prime with respect to number of rows R. Also, setting is performed so that the total of all sub-block sizes is greater than the size of the array used for interleave pattern generation. That is to say, when the number of sub-blocks is designated Ms, output sub-block size Ksout is set so that Ksout×Ms≥RC. When K = 45, 11 is selected as the minimum output sub-block size Ksout that satisfies these conditions.

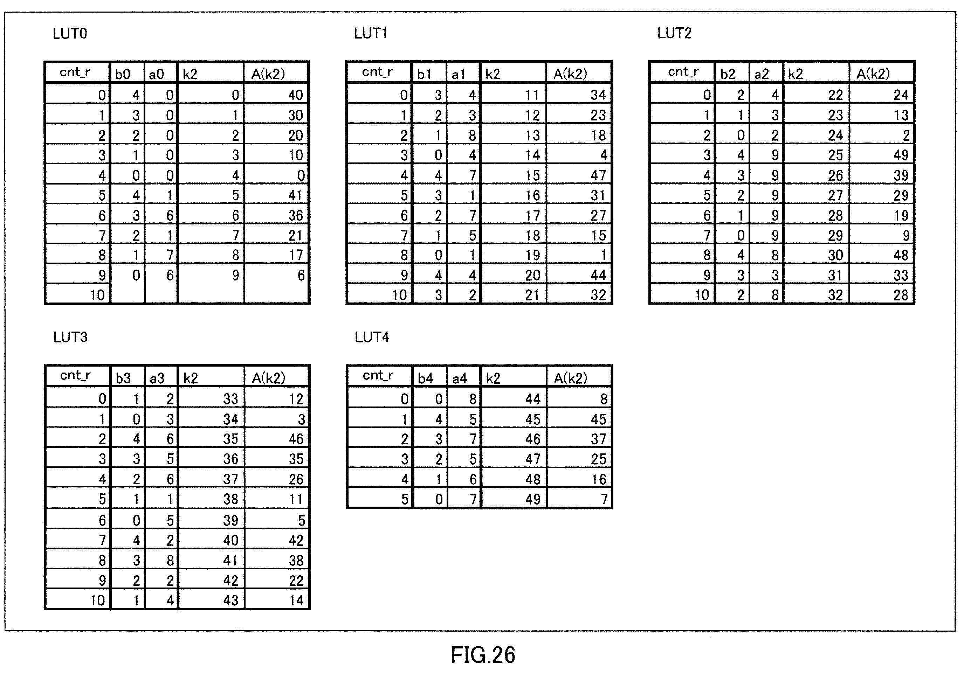

Lookup table (LUT) setting section 112 sets all of LUT0 through LUT4 from the values of data length K and output sub-block size Ksout. Here, an address pattern is set that includes an address of a pruned symbol (invalid address). FIG.26 shows the contents of LUT0 through LUT4 when K = 45. For example, LUT2 counter value cnt_r = 3 is one invalid address since it corresponds to A(k2) = 49.

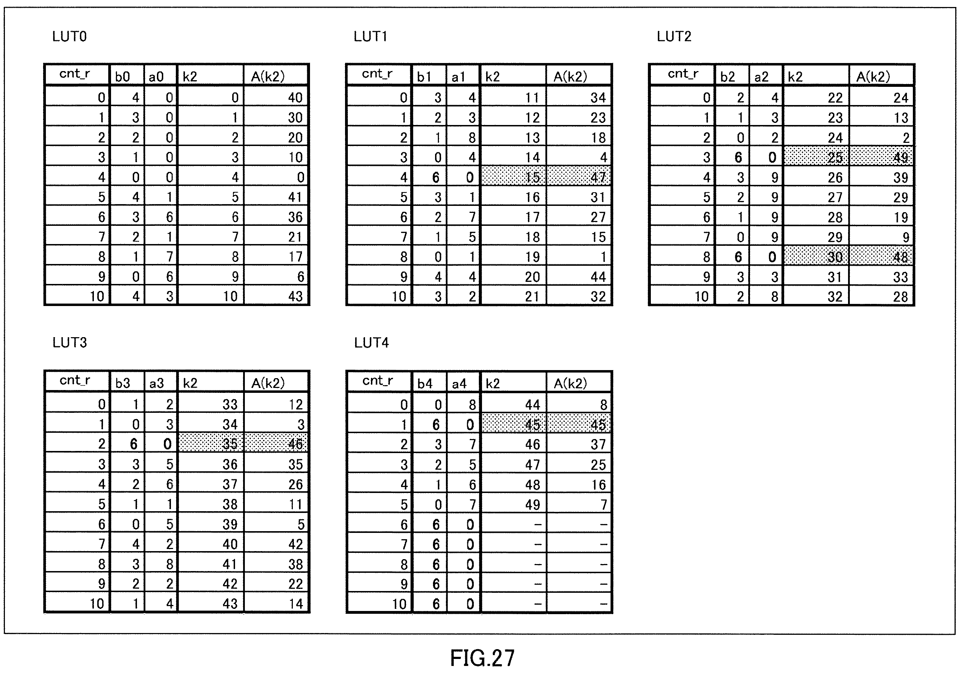

In the case of an invalid address, pruning can be implemented by controlling address switch 114 so that an address is not transferred to RAM0 through RAM4. Address switch 114 control can easily be performed by rewriting the value of bank number b as a special value for a place corresponding to an invalid address as shown in FIG.27. A value indicating invalidity is also set in an empty part of an LUT.

After the above-described initial settings have been completed, parallel interleaving is executed by means of a write phase and a read phase.

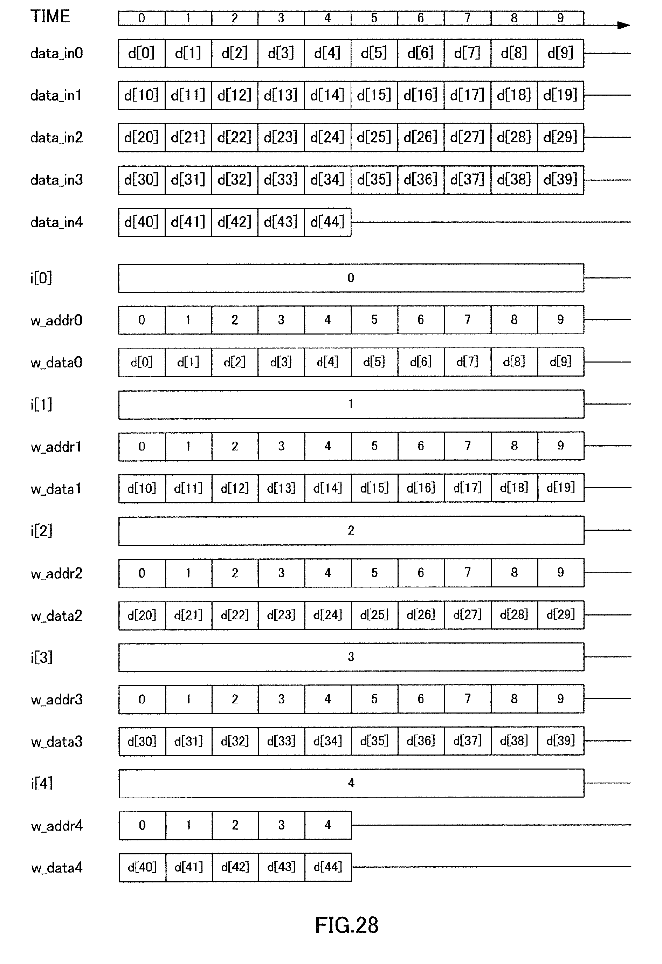

The write phase operation is the same as when pruning does not occur. A timing chart is shown in FIG.28.

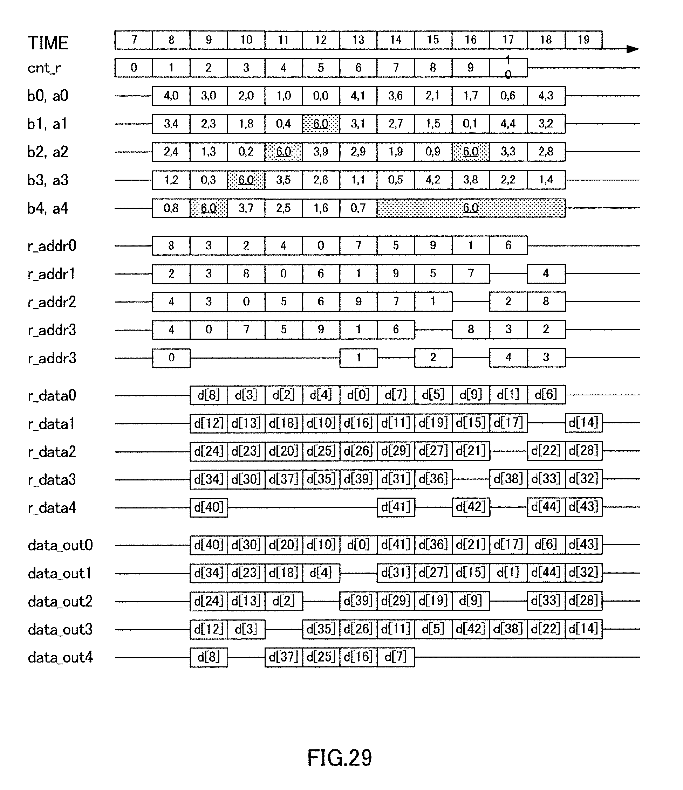

In the read phase, a different operation is performed only when data (b = 6, a = 0) indicating an invalid address is output from LUT0 through LUT4. This will be explained using the timing chart in FIG.29. At time 9, LUT0 through LUT4 outputs b0 through b3 have values of 3, 2, 1, and 0 indicating a bank number, but b4 has a value of 6 indicating an invalid address. In response to this, address switch 114 sends valid addresses a0 through a3 to RAM0 through RAM3, but sends an arbitrary address (for example, 0) to RAM4, or makes the RAM4 read invalid. Then validity detection section 115 reports the fact that sub-block 4 output is invalid to an extrinsic device (for example, an SISO decoder) via a valid[4:0] signal.

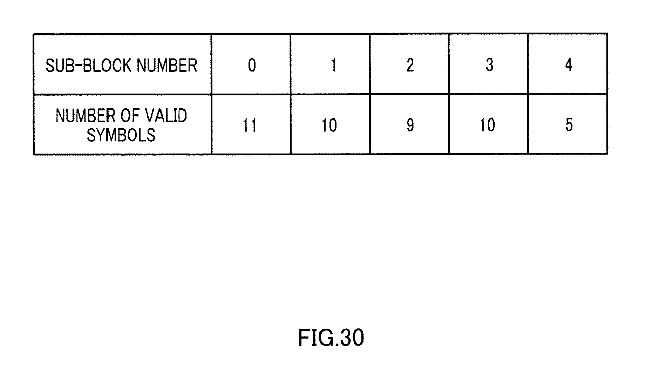

By repeating the above, interleave processing can be completed as shown by data_out0 through data_out4 in FIG.29. The size of each output sub-block is shown in FIG.30. Whenpruning does not occur, the output sub-block size matches Ksout except for the last block, whereas when pruning occurs the output sub-block size may be shorter than Ksout.

### (Embodiment 2)

In Embodiment 1, the basic principles for enabling parallel interleaving to be performed without causing contention were presented. In this embodiment, a configuration and method are proposed that further make possible (1) simplification of write processing, (2) simplification of read processing, (3) modification of the sub-block size determination method, and (4) provision for fewer sub-blocks.

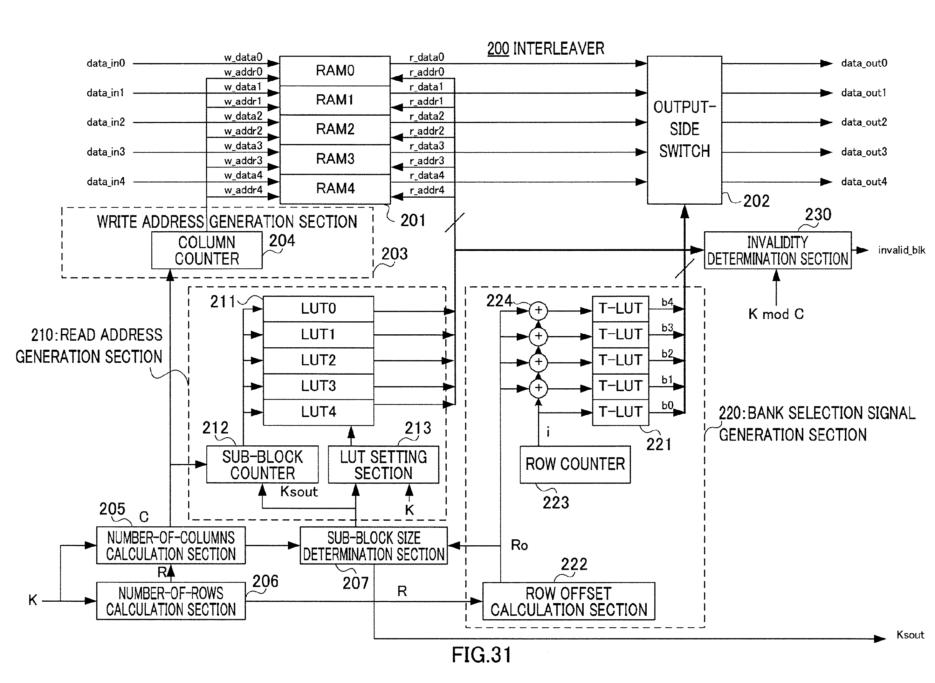

FIG.31 shows the configuration of an interleaver of this embodiment. Interleaver 200 in FIG.31 has a circuit configuration that makes above items (1) through (3) possible. Interleaver 200 also has a simpler circuit configuration than interleaver 100 of Embodiment 1.

Interleaver 200 broadly comprises memory 201 comprising a plurality of independently writable and readable banks (RAM0 through RAM4), an output-side switch 202, a write address generation section 203 comprising a column counter 204, a number-of-columns calculation section 205, a number-of-rows calculation section 206, a sub-block size determination section 207, a read address generation section 210, a bank selection signal generation section 220, and an invalidity determination section 230.

### (1) Simplification of write processing

Fixing the input sub-block size at C makes an input-side switch and row counter unnecessary, and enables column counter 204 of write address generation section 203 to be simplified. That is to say, when input sub-block size Ksin = C, sub-block [k] data is all written to RAM [k] of memory 201. Therefore, by directly connecting data in[k] to w_data[k], an input-side switch and a counter for performing switch control are made unnecessary. Also, since all data are written to the same addresses at each point in time, a single column counter 204 is sufficient (this can also be seen as i [k] = k, j [0 ] = j[1] = ... = j[k-1] always applying).

### (2) Simplification of read processing

In read control in FIG.21 shown in Embodiment 1, the data bank number and address for reading of each sub-block is found by means of LUT0 through LUT4, and reading is implemented by sending an address to the relevant bank using address switch 114. Here, an address switch can be made unnecessary by permuting data in LUT0 through LUT4 beforehand. Specifically, an address to be sent to RAM0 is stored in LUT0, and an address to be sent to RAM[b] is stored in LUT[b]. This table permutes intra-row permutation pattern U[i](j). For example, storage in LUT0, in order from entry 0, is as follows: U[0] (0), U[0] (v), U[0] (2v), ..., U[0] (tv mod Ksout). Here, v = Ms×R/Mr. The t'th entry in LUT [k] is LUT [k] (t) = U[k] ((tv+j0[k]) mod Ksout). Here, j0[k] = floor(Ksoutxk/v).

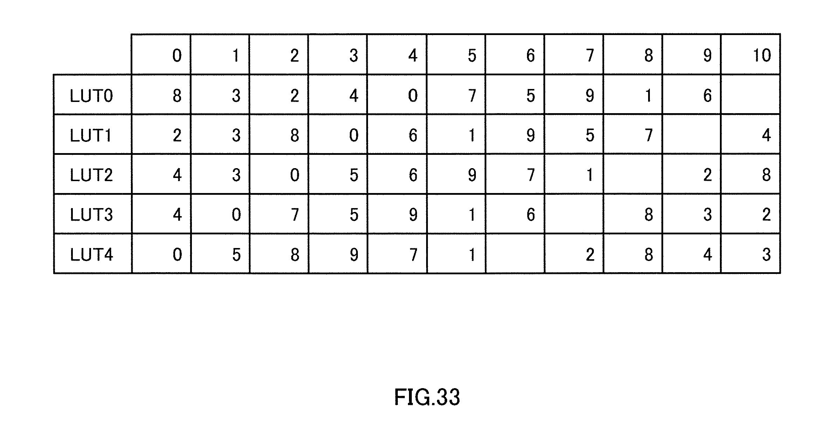

As an address switch is thus made unnecessary, and it is no longer necessary to store bank selection numbers in an LUT, LUT capacity can be reduced. In the case of a 3GPP-standard turbo coding internal interleaver, an LUT can be reduced from 13 bits to 8 bits per word. The contents of LUT0 through LUT4 when K = 45 are shown in FIG.33.

However, bank numbers are necessary separately for control of output-side switch 202. Also, since a special bank number indicating an invalid address is not stored in LUT0 through LUT4, a different method must be used to perform validity determination.

First, the circuit configuration for finding a bank number - that is, bank selection signal generation section 220 - will be described. Bank selection signal b[k](t) for time t is b[k](t) = T[(t+k×Ksout) mod R]. Here, writing i = t mod R, and Ro = Ksout mod R, gives b[k] (t) = T [ (i + k×Ro) mod R].

From the above, a circuit that generates a bank number (that is, bank selection signal generation section 220) can be configured by providing a row counter 223 that counts i = 0 to R-1, a row offset calculation section 222 that finds row offset Ro = Ksout mod R, an R-entry LUT 221 (T-LUT), and a modulo R adder (that finds the remainder of R after addition) 224.

Next, an example of a circuit that performs validity determination (invalidity determination section 230) will be given. Here, a circuit is shown that checks whether or not an access to RAM4 is valid, and if it is invalid, outputs the number of the invalid sub-block. Although it depends on the interleave method, pruning generally occurs in a latter-half bank. Therefore, it is sufficient to provide an invalidity determination circuit for each bank in which pruning occurs. For example, with a PIL, pruning may occur in row 17 onward, and it is therefore necessary to provide three invalidity determination circuits for RAM17, RAM18, and RAM19.

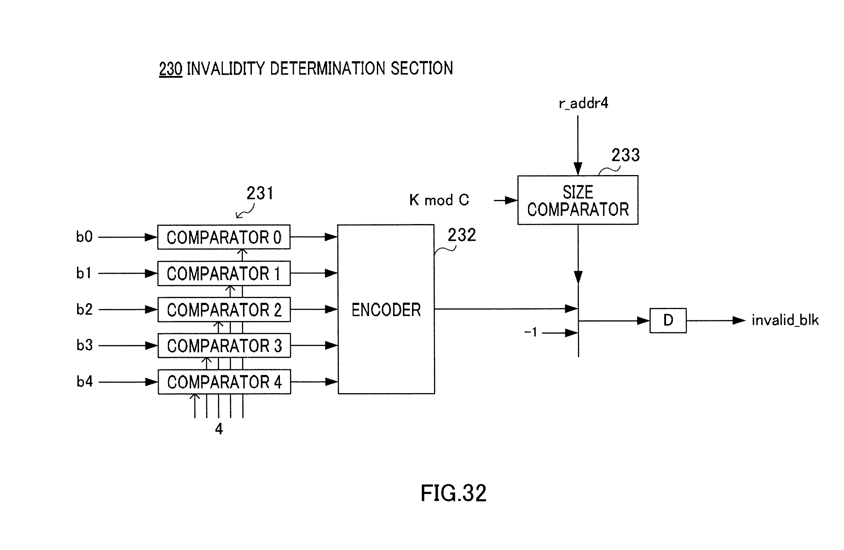

The actual circuit configuration of invalidity determination section 230 will now be described using FIG.32. Invalidity determination section 230 has a comparison section 231, an encoder 232, and a size comparator 233. Five comparators 0 through 4 making up comparison section 231 compare T-LUT output with a bank number to be checked (here, 4) . Here, this is equivalent to checking which sub-block RAM4 output is to be output to. Comparators 0 through 4 output 1 if T-LUT output matches the bank number being checked. When this output 1 is input to encoder 232, encoder 232 performs conversion to a bank number.

At the same time, size comparator 233 compares r_addr4 with K mod C. RAM4 output is invalid if r_addr4 is larger, or the two match. Therefore, in such a case, size comparator 233 controls a selector so that encoder output is connected to an invalid_blk signal, indicating that the relevant sub-block is invalid. If the size comparison result shows that r_addr4 output is valid, no bank number is output in invalid_blk, and a value such as -1, for example, is output.

Two methods of determining whether or not sub-block output is valid have thus been shown above. One is to set data indicating an invalid address in an LUT beforehand as shown in FIG.21 of Embodiment 1, and the other is to use a circuit (invalidity determination section 230) that makes a determination based on a bank selection signal and a read address as shown in FIG.31 of this embodiment.

In actuality, invalidity determination such as described above is extremely important. For example, with a conventional parallel interleaver, invalid addresses are generally excluded when creating an address table. However, in this embodiment, the non-occurrence of memory access contention is actually guaranteed by keeping invalid addresses. For this reason, an invalidity determination circuit is provided in this embodiment. Thus, one characteristic of this embodiment is that invalidity determination is performed by a parallel interleaver. This enables an invalid sub-block to be identified in a parallel interleaver.

(3) Modification of sub-block size determination method
Sub-block size determination section 207 in FIG.31 determines sub-block size based on the equation Ksout = ceiling((C-floor(Ro×Ms/R))/Ms)×R+Ro. Here, the circuit configuration can be simplified by fixing the row offset at Ro = 1, for example.

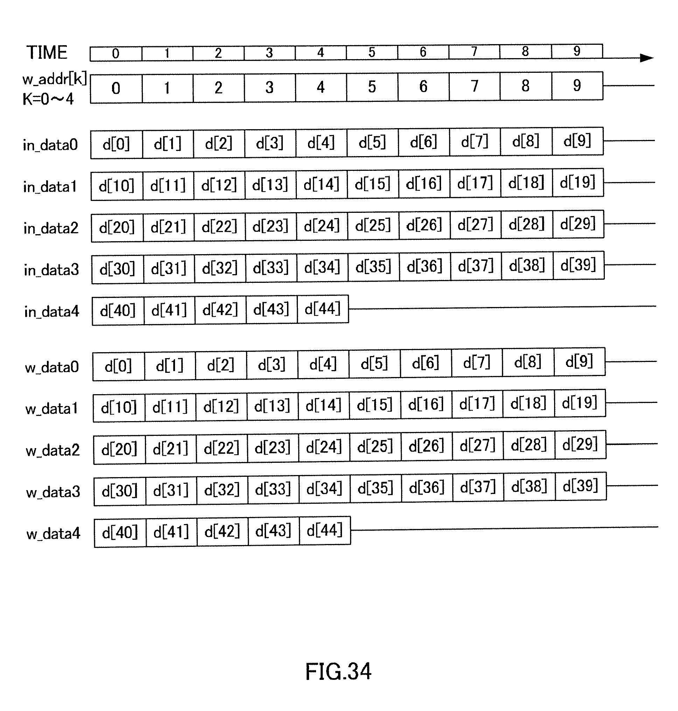

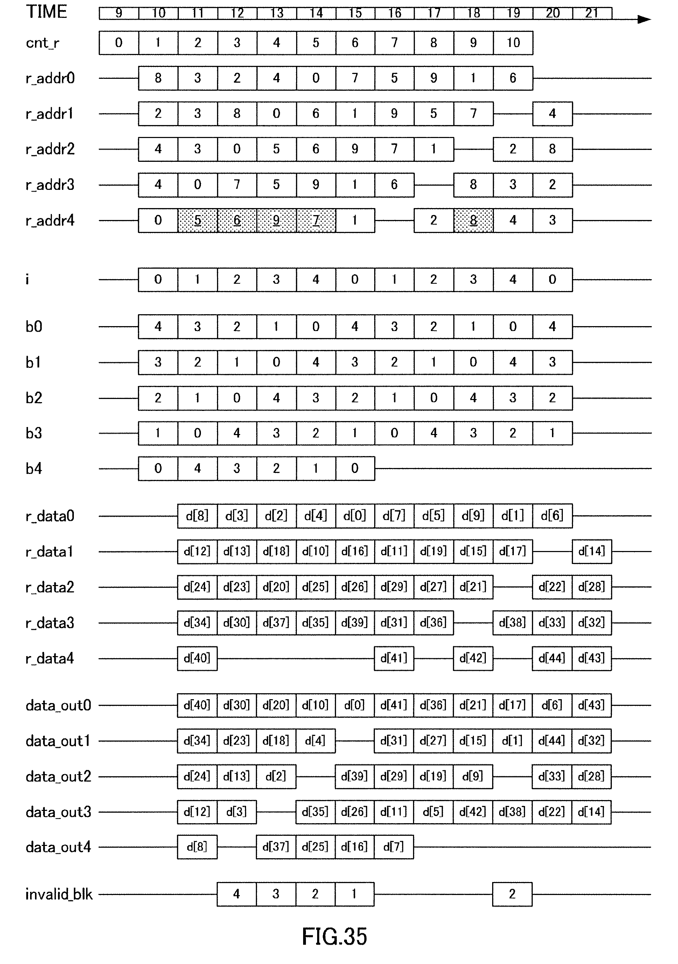

Next, the operation timing of interleaver 200 will be described using FIG. 34 and FIG. 35. FIG. 34 shows write timing, and FIG.35 shows read timing. A case is shown here in which K = 45, Ms = 5, Mr = 5, R = 5, and C = 10.

Particular characteristics of the timing charts are as follows:
(a) Inwrites, itcanbeconfirmedthatallw addr[k] values are the same, and in_data [k] is equal to w_data [k].
(b) In reads, r_addr[k] can be found directly from a table. Shaded parts in r_addr4 are parts corresponding to invalid addresses (pruning). Thus, some data_out signals have parts in which valid data is not output. At these times, the invalid_blk signal is understood to indicate an invalid sub-block.

The configuration of the bank number generation section is not limited to that shown in FIG.31. That is to say, since a row offset value represents displacement of the T-LUT read start position of the relevant sub-block, the need for a circuit for adding an offset can be eliminated by displacing T-LUT contents beforehand in line with the row offset.

Also, since the bank selection signal is varied using R as the cycle, generation can also be performed by a circuit in which R registers are connected in a ring. Since connections between registers vary according to Ro, this configuration may be used when Ro is fixed.

(4) Provision for fewer sub-blocks
With the interleavers described in Embodiment 1 and this embodiment, circuit utilization efficiency can be said to be highest when number of sub-blocks Ms and number of banks Mr are the same. However, when an interleaver with one of these configurations is incorporated in a turbo decoder, it may be necessary to make Ms smaller in the following cases.

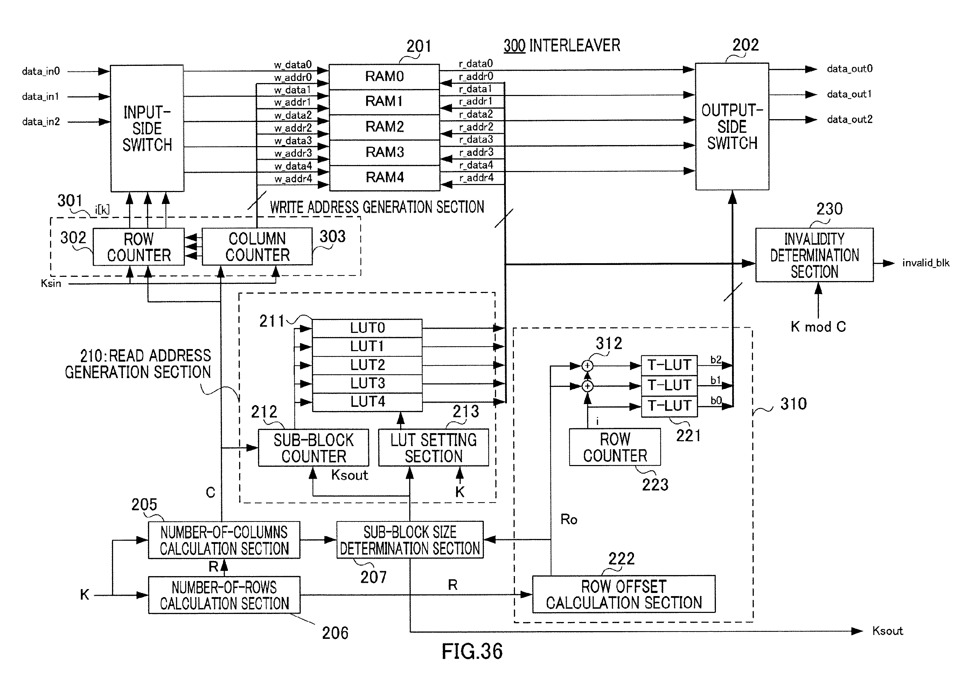

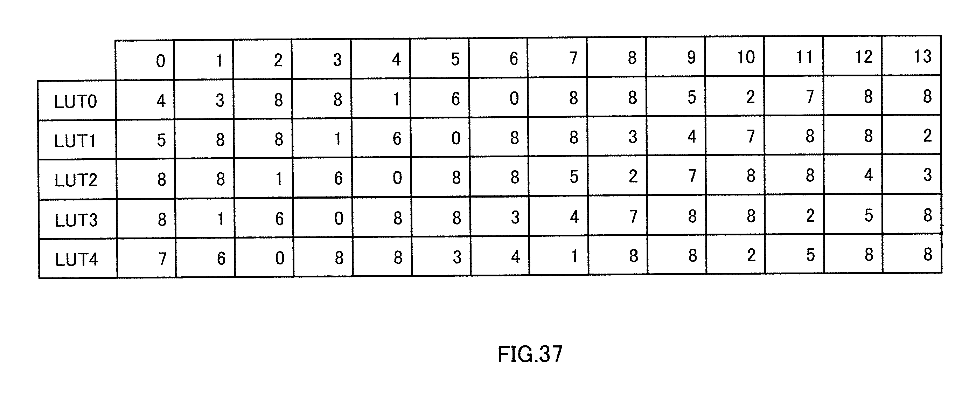

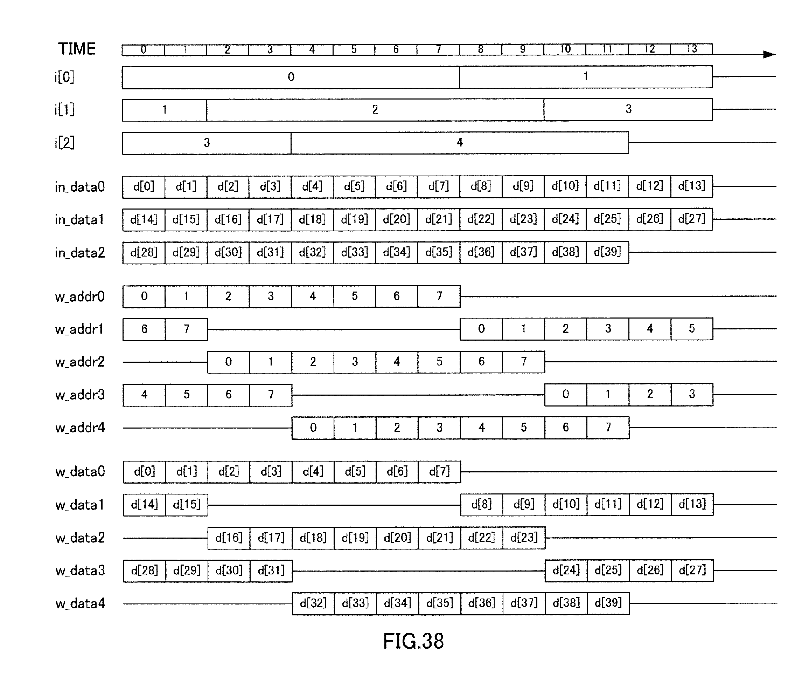

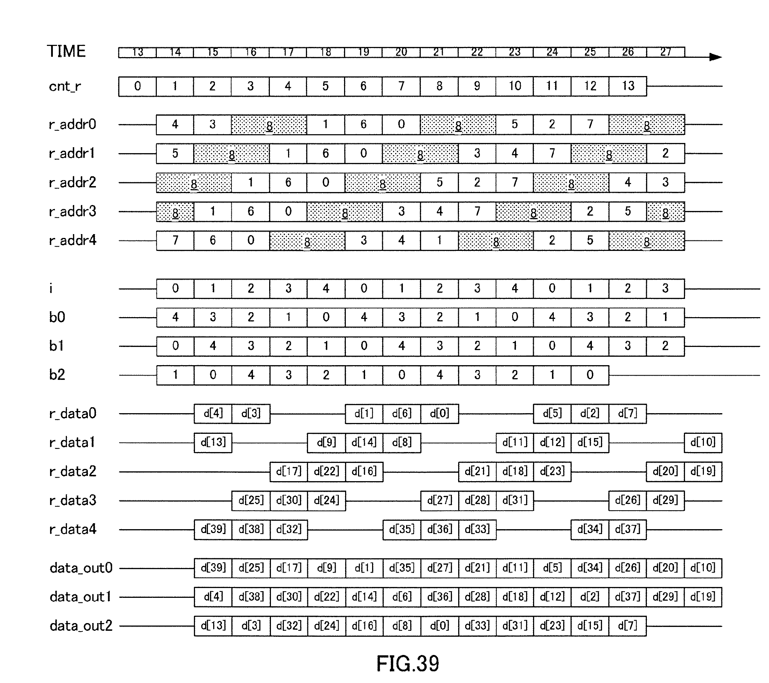

(i) When a SISO (Soft-In Soft-Out) decoder - that is, a computing circuit - has parallel processing capability smaller than Ms
(ii) When decoding performance degrades if the sub-block size is too small
   With the present invention, execution of parallel interleaving without memory access contention is possible even if Ms < Mr. An example in which number of banks Mr = 5 and number of sub-blocks Ms = 3 is shown in FIG.36. In FIG.36, parts corresponding to those in FIG.31 are assigned the same codes as in FIG.31. The contents of LUT0 through LUT4 in the read address generation section of interleaver 300 in FIG.36 are shown in FIG.37, write timing when K = 40, Ksin = 14, Ksout = 14, and Ro = 4 is shown in FIG.38, and read timing in FIG.39.

With regard to write processing, since it is necessary that Ksin × Ms ≥ RC, the condition Ksin = C is not possible. Therefore, a simple configuration cannot be used, and interleaver 300 in FIG.36 has a configuration that includes a write address generation section 301, a row counter 302, and a column counter 303. The respective blocks have three internal counters.

With regard to read control, there are two points of difference from interleaver 200 in FIG.31. First, there are many empty spaces in LUT0 through LUT4 that determine addresses. Since the number of RAMs is 5 whereas the number of sub-blocks is 3, accesses to two of the five RAMs are pointless at any point in time. To deal with this situation, in interleaver 300 an invalid address (an arbitrary value greater than or equal to C, such as 8, for example) is set in the relevant parts of LUT0 through LUT4. Pointless accesses to RAM0 through RAM4 can be prevented by stopping actual accesses when an address greater than or equal to C is input (the section that performs this control is not shown in the figure). Through this control, pointless data is not output to an r_data terminal, as shown in the read timing in FIG.39. However, even if such data is output, that data is ignored by output-side switch 202, and therefore has no effect on data_out.

The second difference involves bank selection signal generation section 310, in which the number of lookup tables 311 (T-LUTs) can be reduced to three in line with the number of sub-blocks.

In interleaver 300, as can be seen from FIG.37 through FIG.39, when invalid address 8 is input to an r_addr terminal, there is no valid output from the r_data terminal. However, it can be seen that when permutation is performed by output-side switch 202, appropriately interleaved data sequences are obtained from the three sub-blocks.

A drawback of interleaver 300 is that, since invalid parts of an LUT are filled with a value of 8, the capacity and number of bits of the LUTs increases. If this is a problem, one of the following methods can be used. The first is to use the configuration in FIG.21. The second is to pack valid addresses toward the front of an LUT instead of inserting invalid addresses in an LUT. However, counter value cnt_r cannot be used directly as an LUT read address, and LUT read control becomes somewhat complicated.

### (Embodiment 3)

The interleavers described in Embodiments 1 and 2 are particularly effective when applied to a turbo decoder. In this embodiment, a configuration will be described for a case in which a parallel interleaver of Embodiment 1 or 2 is incorporated in a turbo decoder.

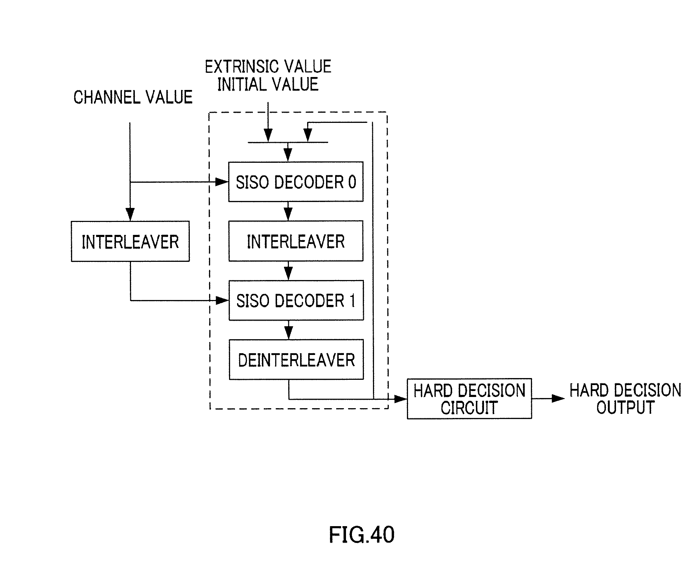

FIG.40 shows a schematic diagram of a currently known turbo decoder. A major feature of this turbo decoder is that, as shown by the area enclosed by a dashed line, information called extrinsic values (or extrinsic information, preliminary information, or the like) is passed between two SISO decoders (Soft-In Soft-Out decoders), and repeated processing is performed. Details are given in the document 'Berrou, C.; Glavieux, A.; Thitimajshima, P.; "Near Shannon limit error-correctingcodingand decoding: Turbo-codes", IEEE International Conference on Communications, 1993, Pages:1064 - 1070 vol.2' and so forth.

In recent years, in order to implement high-speed communication, high-speed processing has also been required of turbo decoders. Known methods of speeding up an SISO decoder are a method whereby a plurality of SISO decoders are operated in parallel, and a radix-4 algorithm (described, for example, in the document 'Charles Thomas, Mark A. Bickerstaff, Linda M. Davis, Thomas Prokop, Ben Widdup, Gongyu Zhou, David Garrett, Chris Nicol; "Integrated Circuits for Channel Coding in 3G Cellular Mobile Wireless Systems", IEEE Communications Magazine August 2003, pp.150-159' and so forth. However, operating a turbo decoder at high speed also requires high-speed operation of an interleaver. A parallel interleaver compatible with the SISO decoder speed-up method is necessary.

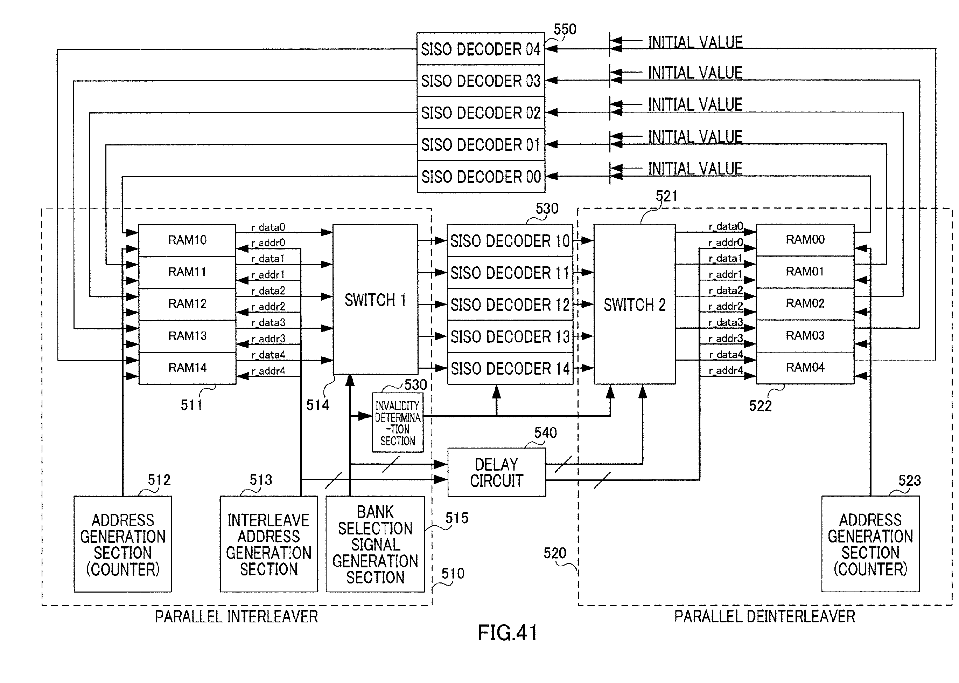

When SISO decoders are operated in parallel, data (extrinsic values) are divided into sub-blocks. Parallel turbo decoder circuitry that uses sub-block division is shown in FIG.41. In this figure, circuitry relating to channel value processing and hard decisions is omitted in order to focus on the flow of extrinsic values. The parallel turbo decoder in FIG.41 broadly comprises a parallel interleaver 510, a parallel deinterleaver 520, SISO decoders 530, a delay circuit 540, and SISO decoders 550. Parallel interleaver 510 has memory 511, an address generation section 512, an interleave address generation section 513, a switch 514, a bank selection signal generation section 515, and an invalidity determination section 516. Parallel deinterleaver 520 has a switch 521, memory 522, and an address generation section 523.

In FIG.41, a total of ten SISO decoders - SISO decoders 00 through 04 and 10 through 14 - are used, but implementation is also possible with only five SISO decoders by performing time division sharing of SISO decoders 00 through 04 and 10 through 14.

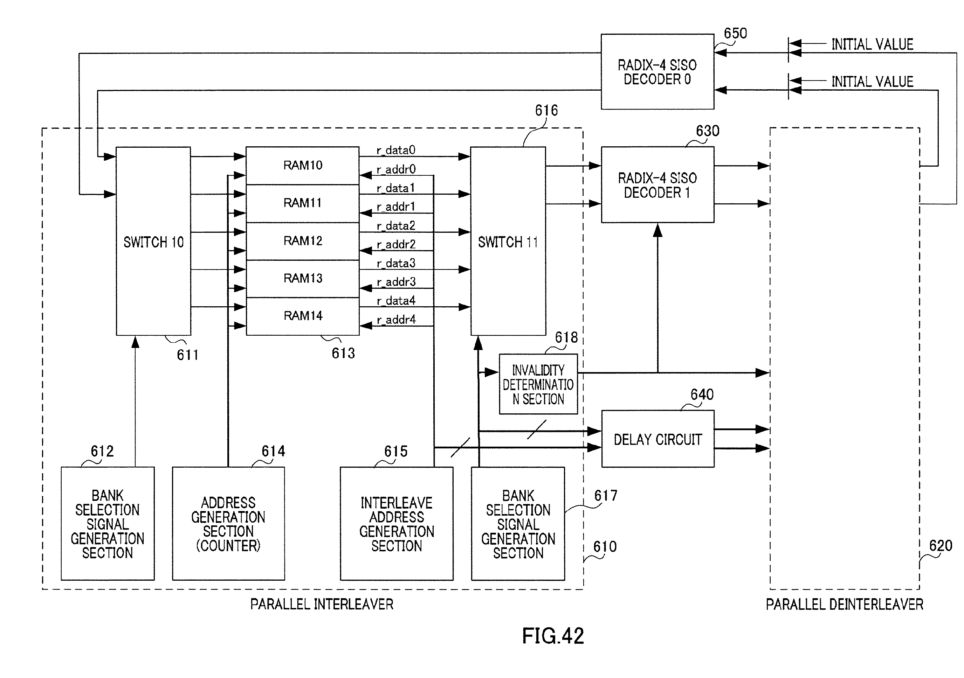

Also, serial-parallel type interleavers can be utilized for SISO decoders using a radix-4 algorithm. A turbo decoder circuit incorporating these is shown in FIG.42. The turbo decoder in FIG.42 broadly comprises a parallel interleaver 610, a parallel deinterleaver 620, a Radix-4 SISO decoder 630, a delay circuit 640, and a Radix-4 SISO decoder 650. Parallel interleaver 610 has a switch 611, a bank selection signal generation section 612, memory 613, an address generation section 614, an interleave address generation section 615, a switch 616, a bank selection signal generation section 617, and an invalidity determination section 618.

As described above, according to the present invention a high-speed interleaver circuit can be implemented with a simple configuration without involving an increase in circuit scale due to the addition of an arbiter circuit or the like, enabling a small, high-speed turbo decoder circuit to be realized.

In above Embodiments 1 and 2, cases in which the present invention is used for a prime interleaver have been described, but the present invention is not limited to this, and can be widely applied to cases in which an interleave algorithm is implemented that writes data on a row-direction priority basis to a rectangular matrix data structure, performs intra-row permutation for each row, permutes rows, and reads out data on a column-direction priority basis.

### (Embodiment 4)

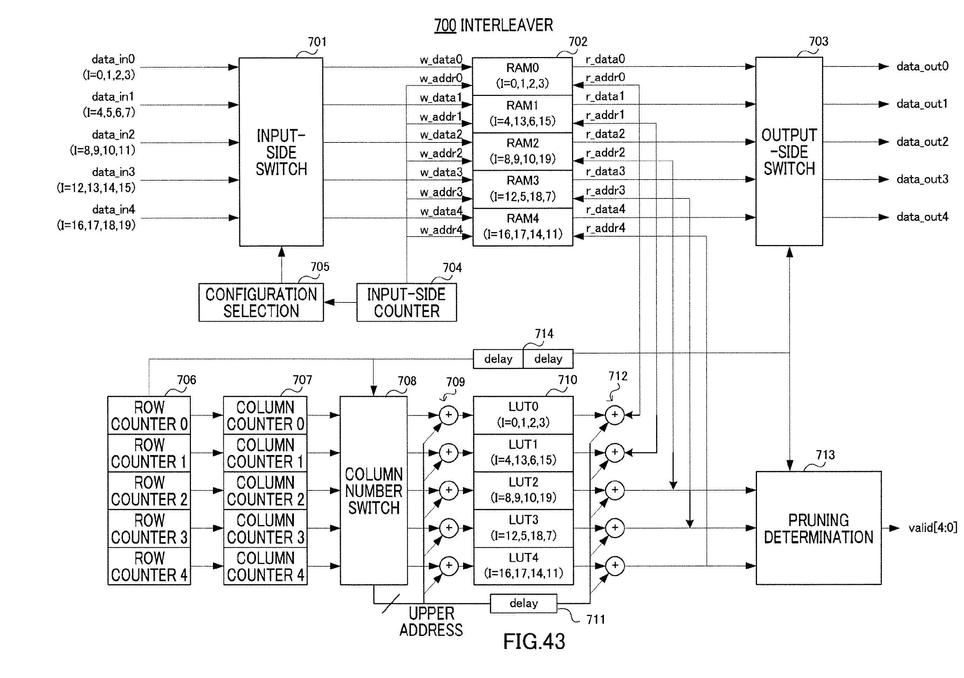

FIG.43 shows the configuration of an interleaver of this embodiment. This interleaver 700 has an input-side switch 701, memory 702 comprising a plurality of independently writable and readable banks (RAM0 through RAM4), an output-side switch 703, a write address generation section comprising an input-side counter 704 and configuration selection section 705, row counters 706, column counters 707, a column number switch 708, an adder 709, an address table 710 comprising lookup tables LUT0 through LUT4, a delay section 711, an adder 712, and a pruning determination section (corresponding to validity detection section 115 in FIG.1) 713.

### (1) Design method and principles

First, before describing interleaver 700 in detail, the principles of this embodiment will be explained.

In this embodiment, as an example, a circuit is described that performs parallel interleaving of 20 rows, using five RAMs and five parallel inputs/outputs (division into five sub-blocks). In this embodiment, data with a block size of 203 will be taken as an example. With a 3GPP standard PIL, in an interleaver array, number of rows R = 20 and number of columns = 11.

The input block size should be a multiple of C. Here the block size is assumed to be 4 times C - that is, 44. (A figure of 4 per block was arrived at since the number of rows is 20 and the degree of parallelism (number of sub-blocks) is 5.)

Output sub-block size Ksout is determined so as to satisfy the following two conditions.
(i) The remainder after dividing Ksout by R is 1 or more.
(ii) The number of rows assigned to one bank does not exceed the greatest common divisor of Ksout and R.
   An easy method of finding such a Ksout is to make Ro = 4 in Equation (1). The remainder after dividing Ksout by R is 4. Also, since the greatest common divisor of Ksout and R is 4, four rows can be assigned to one bank. From the above, Ksout is made 44.

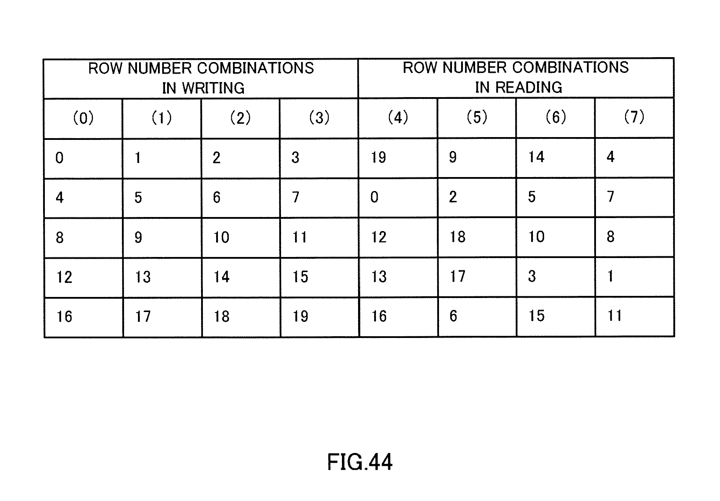

Next, data and memory bank provisions are determined.
The input block size has been made a multiple of C. Therefore, in the first C cycles of a write operation, for sub-block 0, row 0 data is written to memory, for sub-block 1, row 5 data is written to memory, .... Then, in the next C cycles, for sub-block 0, row 1 data is written, for sub-block 1, row 5 data is written, ....
From the above, when combinations of data written simultaneously are expressed by row numbers, there are four kinds as shown in (0) through (3) in FIG.44.

When reading, combinations per cycle vary. As output sub-block size Ksout has been made 44, the number of combinations is 20, and there are no simultaneous accesses to the same row (contention does not occur). Furthermore, in this embodiment, because remainder Ro after dividing Ksout by R has been made 4, duplication occurs in the combinations, and these are reduced to the four shown in FIG.44.

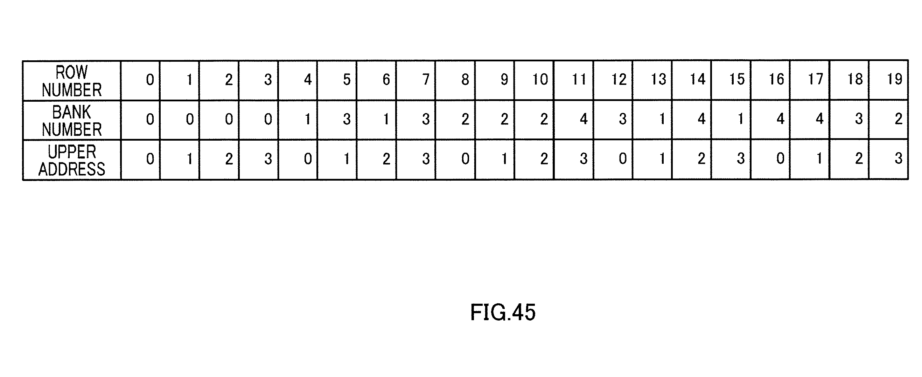

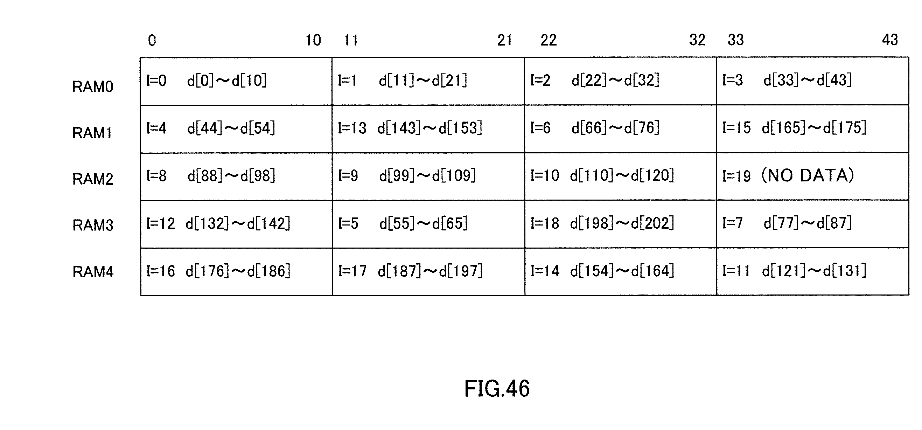

From the above, all (eight) combinations of rows accessed simultaneously are clear. Therefore, bank assignment is determined so that these rows are in different banks. One example of assignment is shown in FIG.45 and FIG.46.

The design principles of an interleaver of this embodiment have been explained above. Important points are listed below.
- Because output sub-block size Ksout has been made "44 including dummy data (pruned data)", simultaneous accesses to the same row do not occur when writing.
- Because remainder Ro after dividing Ksout by R has been made 4, the number of combinations of rows that can be accessed simultaneously has been reduced to four.
- The data RAM division method (method of assignment to banks) has been determined so that rows accessed simultaneously are in different banks. The smaller the number of combinations of rows accessed simultaneously, the fewer banks are necessary, and the simpler the circuitry becomes.

### (2) Configuration and operation

Next, the configuration and operation of interleaver 700 of this embodiment will be described.

### <Configuration>

### (Write-related)

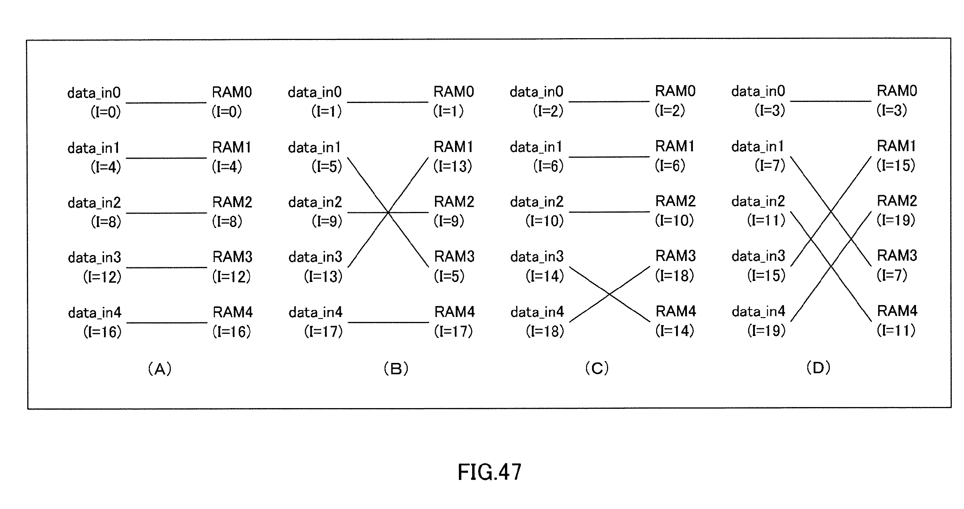

Input terminals (data_in0 through data_in4): One terminal corresponds to one sub-block.
Input-side switch 701: An input terminal is connected to an appropriate RAM bank of memory 702. The switch implements the four connection arrangements shown in FIG. 47 (A) through (D). Which connections are switched to at a particular point in time is determined by configuration selection section 705.
Input-side counter 704: Generates an address for a data write. Configuration selection section 705 operates based on the output of this counter.
RAM0 through RAM4: RAM to which input data is written. Divided into five banks.

### (Read-related)

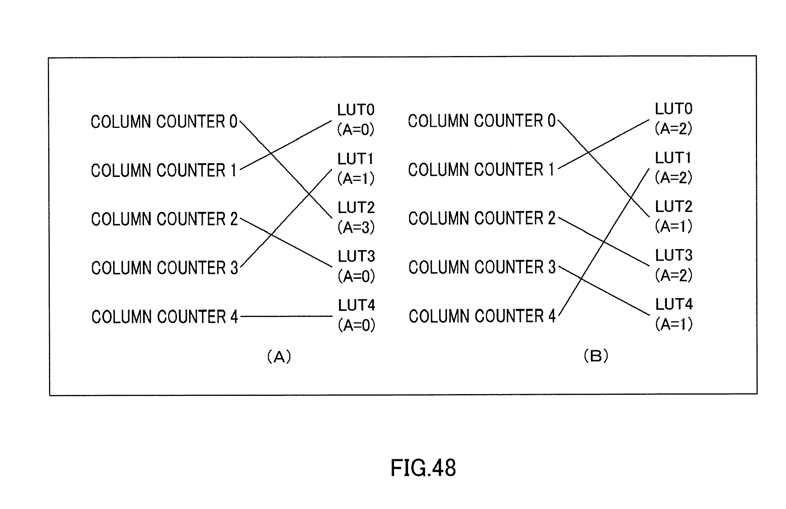

Row counters 706: Hold and update row numbers after interleaving of data to be read by sub-blocks 0 through 4.
Column counters 707: Hold and update column numbers after interleaving of data to be read by sub-blocks 0 through 4.
Column number switch 708: Transfers a column counter 707 value to an appropriate LUT. Implements a total of 20 connection states, besides the two shown in FIG.48 (A) and (B) . Calculates an upper address value to be added to each counter value.
Address table (LUT0 through LUT4) 710: Address table. In this embodiment, in particular, holds an intra-row permutation pattern. Divided into five banks in the same way as data RAM.
Pruning determination section 713: Checks whether an invalid address is included in address table 710 output. If an invalid address is included, pruning determination section 713 checks which sub-block that address corresponds to, and outputs the result to the "valid" terminal.
Output-side switch 703: Connects data output from each bank of memory 702 to the appropriate output terminal.
Output terminals (data_out0 throughdata_out4) : One terminal corresponds to one sub-block.

### <Read operation>

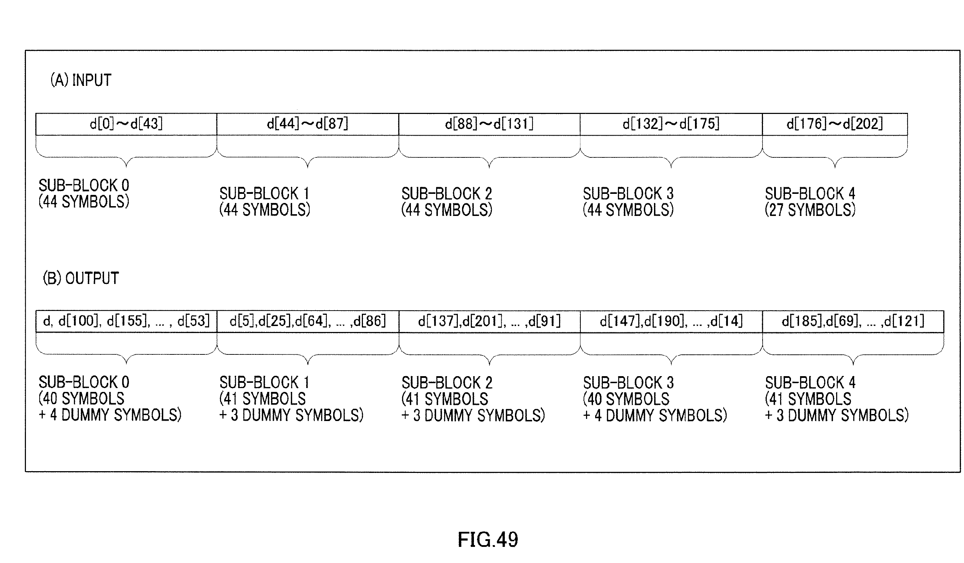

A case in which the block size (data length) is 203 symbols will be described as an example.
In the 3GPP standard (PIL), interleaver array specifications are R= 20, C = 11 . Interleaver 700 divides input data into five sub-blocks. This is illustrated in FIG.49 (A). A latter-half sub-block may be shorter than Ksin. In the example shown in FIG. 49 (A), a latter-half sub-block (sub-block 4) is shorter than the others, with only 27 symbols.

Input data is arranged in memory 702 as shown in FIG.46. Here, supplementary information is included in each figure in the form of expressions based on row number I. For example, the first data of sub-block 3 is I = 12 data, and is written into the first part of RAM3.

In order to perform such writes, the circuit in FIG.21 operates as follows.
Input-side counter 704 counts in units of 1 from 0 to 4C-1. A count value is input to a RAM as a write address. Control of input-side switch 701 is performed in accordance with the count value. That is to say, the connection state of input-side switch 701 is as shown in FIG.47 (A) while the count value is 0 to C-1, and as shown in FIG.47 (B) while the count value is C to 2C-1.

### <Read operation>

In this example, it is assumed that output sub-block size Ksout = 44. Initial settings of counters 706 and 707 are made based on this value.
The data ranking of the first data of output sub-block 0 is 0. Thus, the initial value of row counter 0 is set to 0, and the value of column counter 0 is set to 0.
The data ranking of the first data of output sub-block 1 is 44. Thus, the value of row counter 1 is set to 4, and the value of column counter 1 is set to 2.

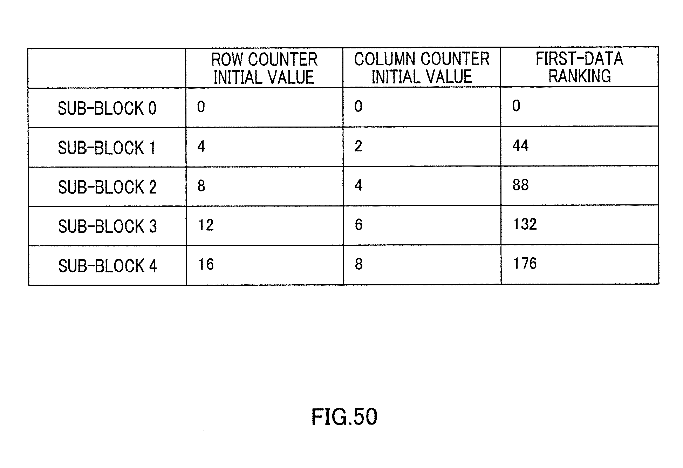

Here, if a row counter is represented by I, a column counter by J, and a data ranking by n, the relationship between these is as shown in the following equation. $n = I + JR$
The initial values of row counter 1 and column counter 1 are calculated from the relationship in Equation (4) and the fact that I is in the range of 0 to 19. Counter values are also calculated in a similar way for sub-blocks 2 through 4. These values and the data rankings are shown in FIG.50.

Here, the data rankings are post-interleaving data rankings that include dummy data pruned away by pruning processing. Therefore, whereas block size K is 203, the last data ranking of sub-block 4 is 219, larger than the block size. (Since 219 - 203 = 16, 16 dummy data have been inserted.)
If counter values are not set based on data rankings including dummy data, it cannot be guaranteed that memory access contention will not occur.

When initial settings are completed, a read operation is started. A row counter 706 is incremented by 1 each cycle, and when the row counter 706 value exceeds maximum row value 19, the row counter 706 is reset to 0, and corresponding column counter 707 is incremented by 1. That is to say, a column counter 707 is incremented once in 20 cycles.

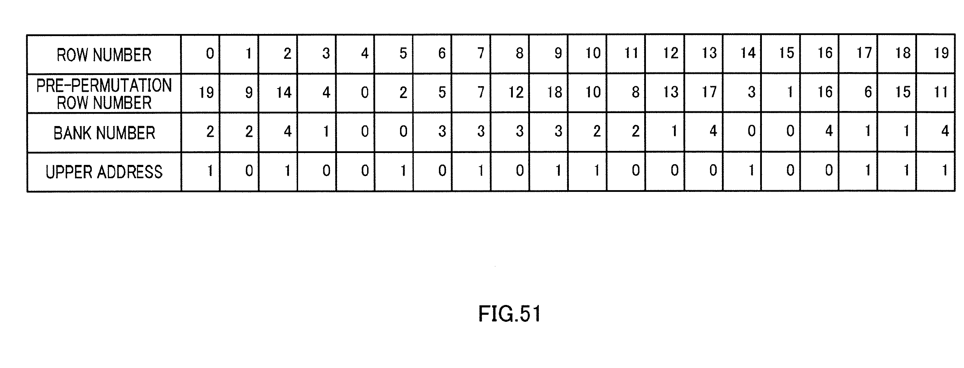

A column counter 707 value is transferred to the appropriate LUT by column number switch 708. Here, column number switch 708 performs the following three tasks:
- Intra-row permutation
- Association between row number and bank number
- Association between row number and position in bank (upper address generation)
These relationships are shown in FIG.51.

The operation of column number switch 708 will now be explained in detail. In the initial cycle (at the time of initial settings) the values of row counter 3 and column counter 3 are 12 and 6 respectively. The pre-inter-row permutation row number corresponding to this row number is 13. As data belonging to row 13 prior to permutation is in bank 1 (RAM1), column number switch 708 is connected as shown in FIG.48.

Also, row 13 data has been stored in the second area from the front of bank 1. Therefore, a value A = 1 that is an upper address indicating this is generated by column number switch 708. The value A = 1 is converted to an actual address (the address at which the A = 1 area begins), and is added to the column counter value.
As a result, a value of 17 (= 6 + 11) is input to LUT1. LUT1 outputs a value of 4, being the intra-row permutation pattern corresponding to 12 rows and 6 columns.

An upper address is added to this output again, and the result is output to RAM as an address. That is to say, an address value of 15 (= 4 + 11) is output to RAM1, and d[147] is output from RAM.
Output-side switch 703 performs connections in the reverse direction to column number switch 708. That is to say, RAM1 output is connected to sub-block 3 (data_out3).

In this way, d[147] is output as sub-block 3 data in the initial cycle of a read operation. The situation regarding all outputs is shown in FIG.49 (B).

With a parallel interleaver of the present invention, invalid data may be output in some sub-blocks. Pruning determination section 713 checks whether or not the data of each sub-block is valid. If data is invalid, a signal indicating invalidity is output.

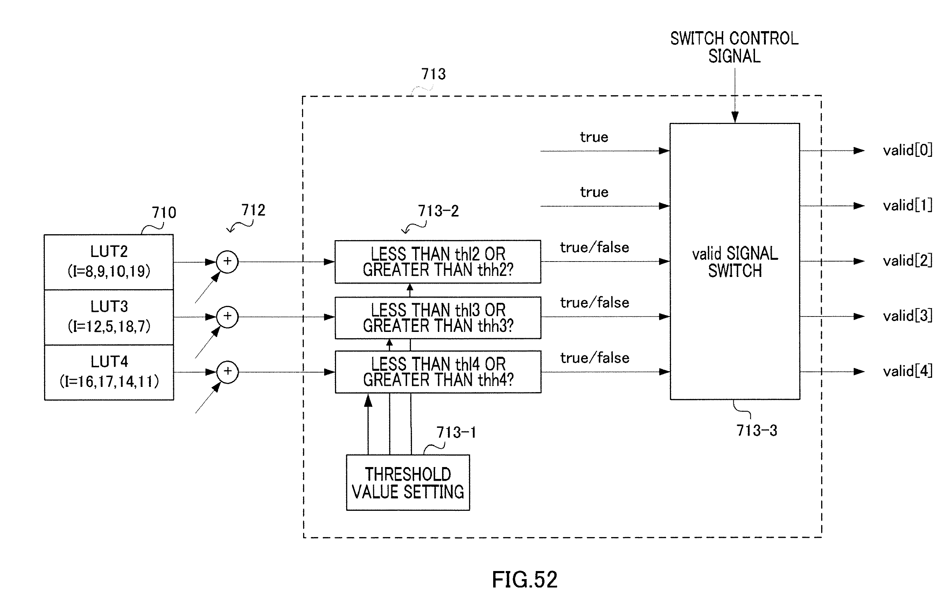

FIG. 52 shows the circuit configuration of pruning determination section 713. Pruning determination section 713 has a threshold value setting section 713-1, a threshold value determination section 713-2, and a valid signal switch 713-3. Threshold value determination section 713-2 specifies an address of an area of each RAM in which invalid data is held. For example, in the case of a block size of 203, row 19 is all invalid, and therefore addresses 33 through 43 of RAM2 are invalid. Also, only the first five symbols of row 18 are valid, and therefore addresses 27 through 32 of RAM3 are invalid. Here, thl indicates the address at which invalid data begins, and thh the address at which invalid data ends. Pruning does not occur in RAM4.
Threshold value determination section 713-2 determines whether or not an address output from address table 710 is in an invalid area, returning "true" if an address is valid, or "false" if invalid. By this means, it can be determined whether or not output of each RAM is valid.
Valid signal switch 713-3 operates in a similar way to output-side switch 703. As a result, a 5-bit signal valid[4:0] indicating which sub-blocks are valid is output.

### (Embodiment 5)

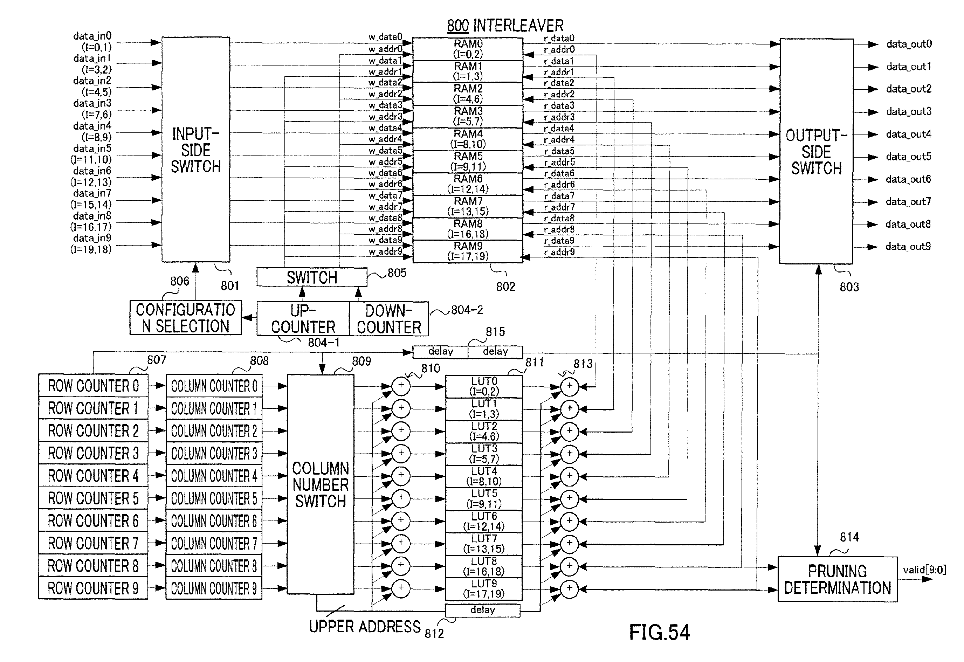

FIG.54 shows the configuration of an interleaver of this embodiment. This interleaver 800 has an input-side switch 801, memory 802 comprising a plurality of independently writable and readable banks (RAM0 through RAM9), an output-side switch 803, an up-counter 804-1, a down-counter 804-2, a write address generation section comprising a switch 805 and configuration selection section 806, row counters 807, column counters 808, a column number switch 809, an adder 810, an address table 811 comprising lookup tables LUT0 through LUT9, a delay section 812, an adder 813, and a pruning determination section 814.

### (1) Design method and principles

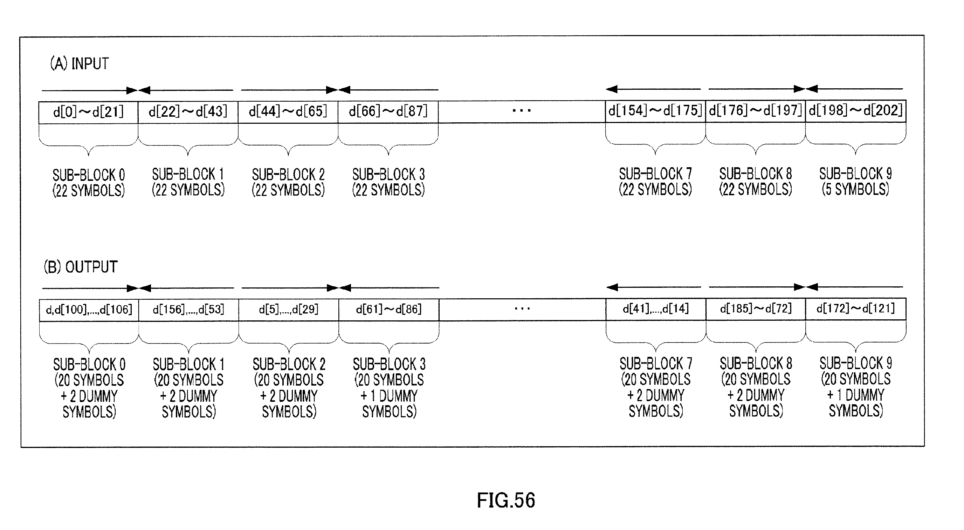

First, before describing interleaver 800 in detail, the principles of this embodiment will be explained.
In a turbo decoder, it is often useful to reverse the data input order. Thus, in this embodiment the input/output order is reversed only for odd-numbered sub-blocks. This is illustrated in FIG.56.
In this case, also, a parallel interleaver in which contention does not occur can be implemented in the same way as in Embodiment 4. An example in which the block size is 203 will be described. In this embodiment, the degree of parallelism is assumed to be 10.

The input sub-block size is assumed to be 22, and the output sub-block size is assumed to be 22. Here, the sub-block size is determined using Equation (1), taking Ro as 2 since the degree of parallelism is 10 (R ÷ 10 = 2). The way in which sub-block division is performed is shown in FIG.56.

A point to be noted here is that, when there is a mix of ascending-order and descending-order sub-blocks, contention will not necessarily be prevented from occurring by following Equation (1). In the final analysis, careful design is necessary so that "with regard to two or more simultaneously read out data, for any two or more, the remainder after the difference in post-interleaving data ranking is divided by the number of rows is 1 or more."

However, as a simple method, Equation (1) may be used as long as either of the following conditions is met.
(i) The output sub-block size is made an even number.
(ii) Even-numbered sub-blocks are all made ascending-order, and odd-numbered sub-blocks descending-order, or vice versa.

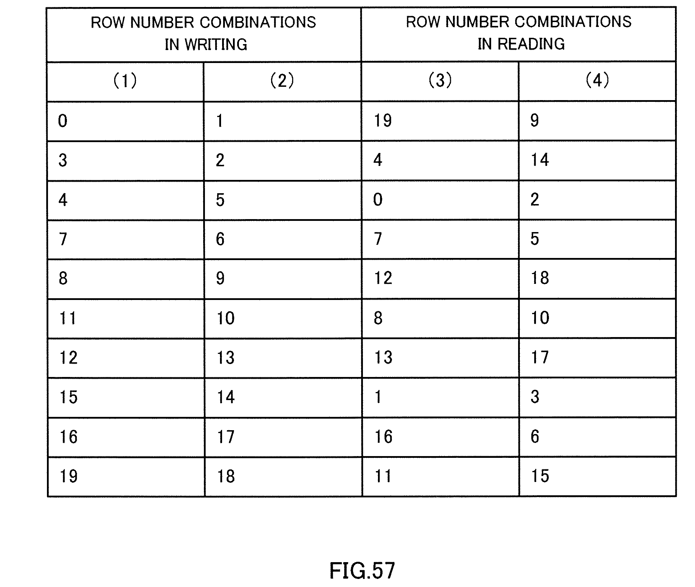

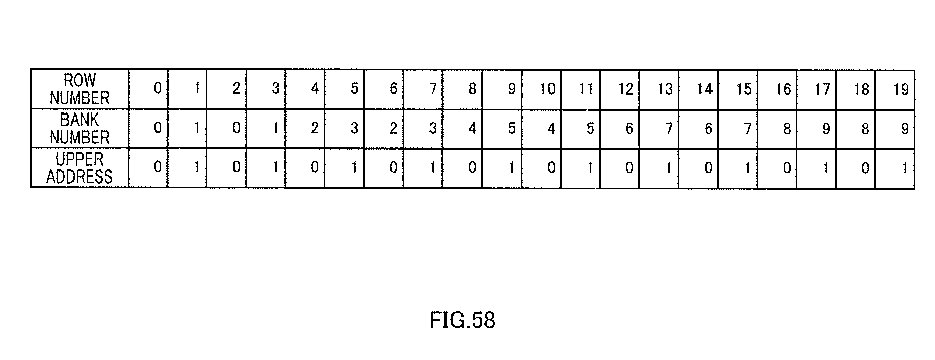

Combinations of simultaneously accessed rows are as shown in FIG.57.
An example of a bank assignment method is shown in FIG.58. To simplify upper address addition in column number switch 809, intra-bank boundaries are set at intervals of 256.

### (2) Operation

Next, the operation of interleaver 800 of this embodiment will be described, focusing on parts that differ from interleaver 700 of Embodiment 4 (FIG.43).

### <Write operation>

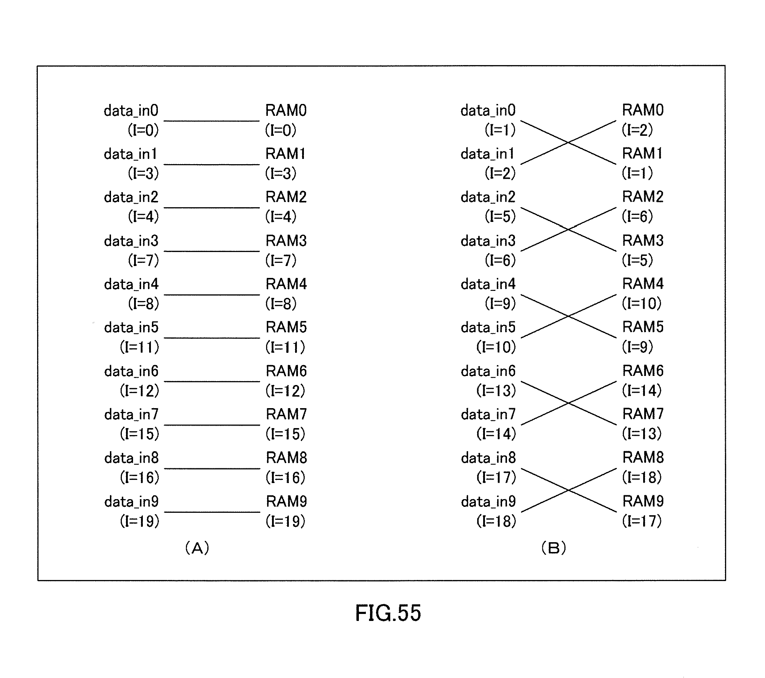

As data is input in the forward direction for even-numbered sub-blocks (sub-blocks 0, 2, ...), this data is written to memory 802 using up-counter 804-1. As data is input in the reverse direction for odd-numbered sub-blocks, this data is written to memory 802 using down-counter 804-2. FIG.55 shows input-side switch 801 configurations.

### <Read operation>

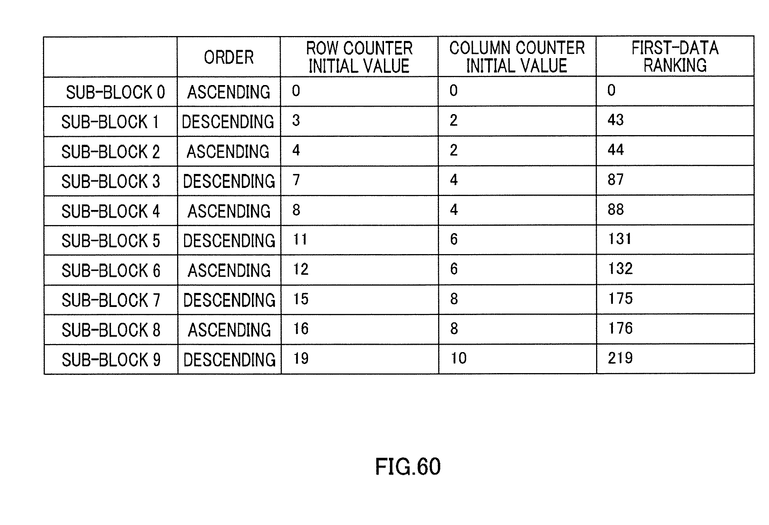

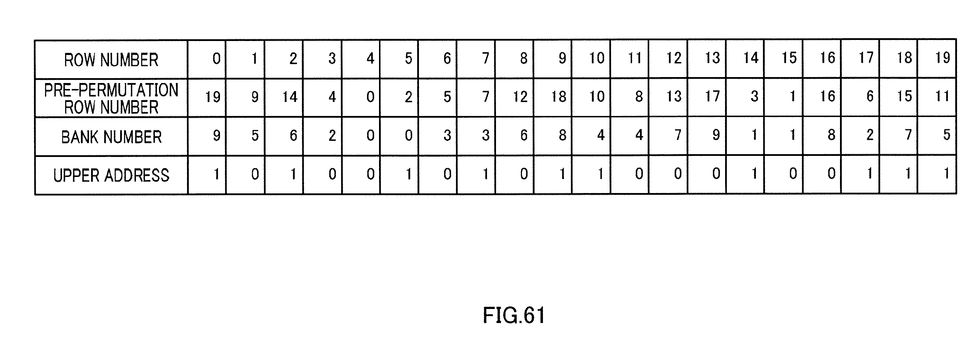

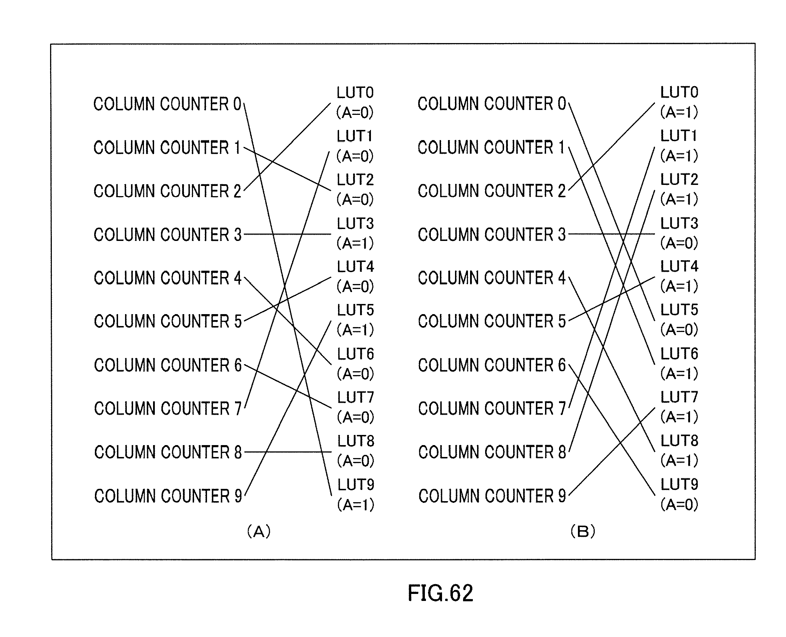

Initial values of row counters 807 and column counters 808 are shown in FIG.60.
A counter for which the sub-block number is odd is a down-counter. That is to say, row counters 807 are decremented by 1 each cycle. When a row counter 807 value reaches 0, it is reset to 19 in the next cycle, and the value of a column counter 808 is decremented.
The value of a column counter 808 is transferred to the appropriate LUT by column number switch 809, in the same way as in Embodiment 4. Here, column number switch 809 performs the tasks of intra-row permutation, association between row number and bank number, and association between row number and position in bank (upper address generation). These relationships are shown in FIG.61.
The operation of input-side switch 801 is similar. FIG.62 shows the first two of the 20 configurations of column number switch 708.
Other operations are the same as for interleaver 700 of Embodiment 4 (FIG.43).

### (Embodiment 6)

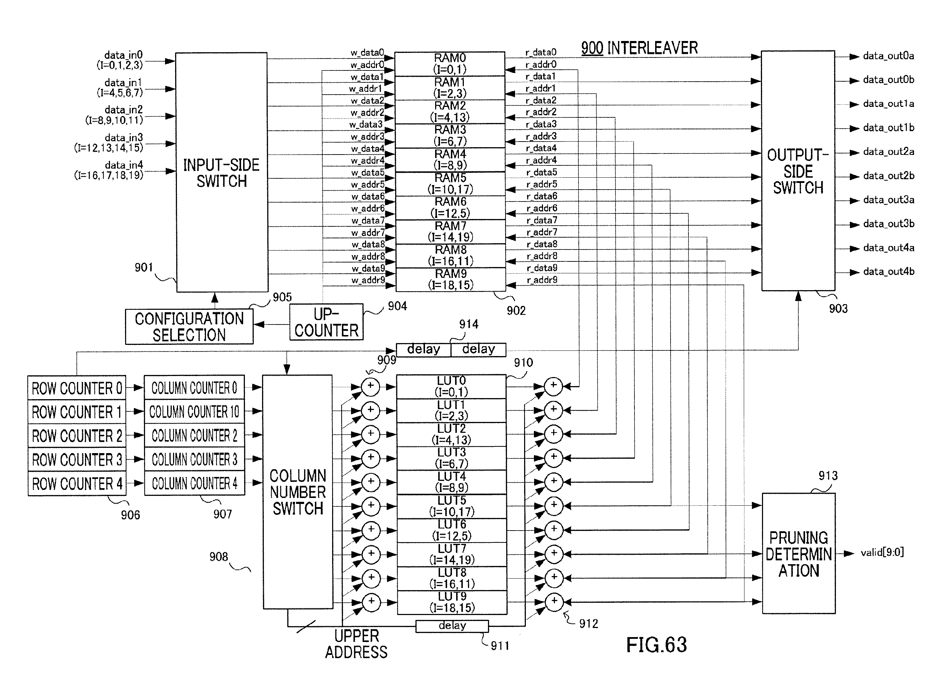

FIG.63 shows the configuration of an interleaver of this embodiment. This interleaver 900 has an input-side switch 901, memory 902 comprising a plurality of independently writable and readable banks (RAM0 through RAM9), an output-side switch 903, a write address generation section comprising an up-counter 904 and configuration selection section 905, row counters 906, column counters 907, a column number switch 908, an adder 909, an address table 910 comprising lookup tables LUT0 through LUT9, a delay section 911, an adder 912, and a pruning determination section 913.

### (1) Design method and principles

First, before describing interleaver 900 in detail, the principles of this embodiment will be explained.
In this embodiment, a hybrid type of parallel interleaver is proposed that combines a sub-block division method with serial/parallel conversion. Here, the degree of parallelism is assumed to be 5 × 2.
As with the previously described embodiments, reads can be performed in parallel without contention.

Writes cannot be performed with a degree of parallelismof 10 with the same kind of methods as described in the above embodiments. Thus, in this embodiment, writes with a degree of parallelism of 5 are assumed. However, writes with a degree of parallelism of 10 are possible if all of RAM is divided into two: even-numbered addresses and odd-numbered addresses. RAM0 is divided into RAMO-even and RAMO-odd. As the parallelization of serial write processing by means of such memory division is already known, it will not be described here.

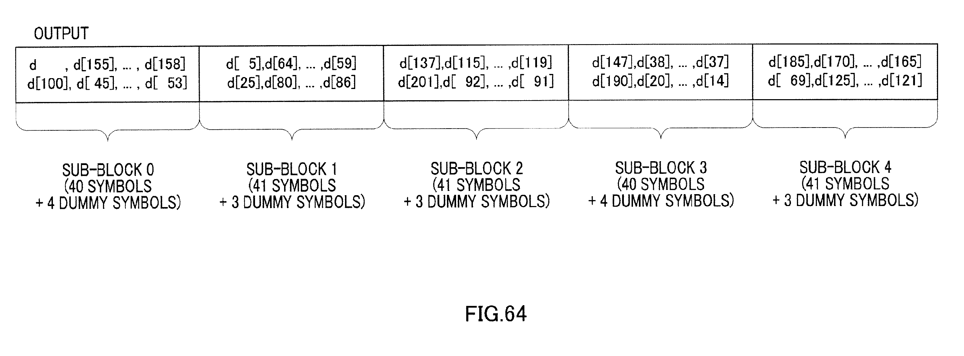

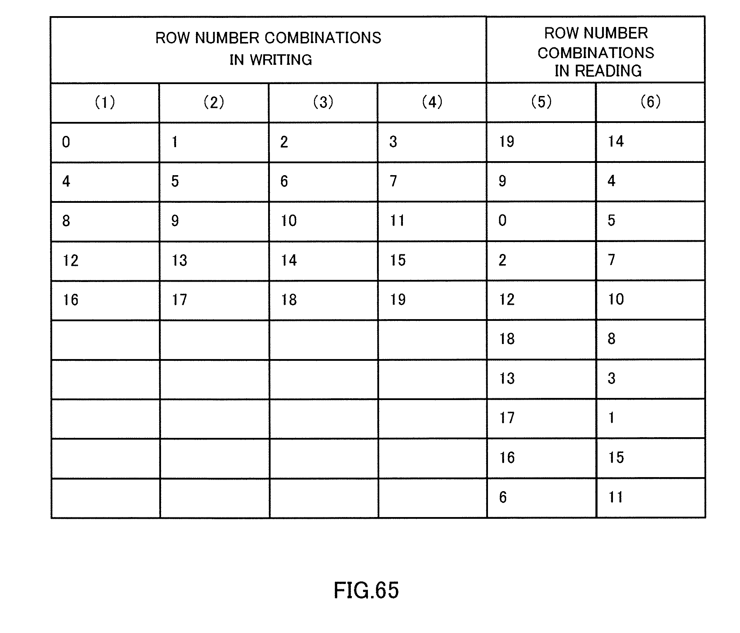

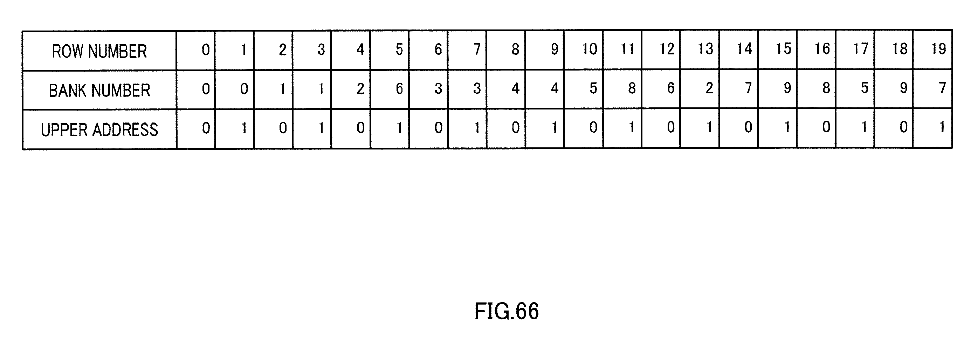

Equation (1) can also be used with a hybrid type of parallel interleaver. However, the sub-block size should be made an even number. Thus, in this example, in which the degree of parallelism is 5 × 2, Ro = 4 is selected, and an output sub-block size of 44 is used.
The way in which sub-block division is performed is shown in FIG.64. For one sub-block, two symbols are output in one cycle.
Combinations of simultaneously accessed rows are as shown in FIG.65. Note that the degree of parallelism of writes is 5, and the degree of parallelism of reads is 10.
Based on the above conditions, bank assignment is determined as shown in FIG.66.

### (2) Operation

Next, the operation of interleaver 900 of this embodiment will be described, focusing on parts that differ from interleaver 700 of Embodiment 4 (FIG.43).

### <Write operation>

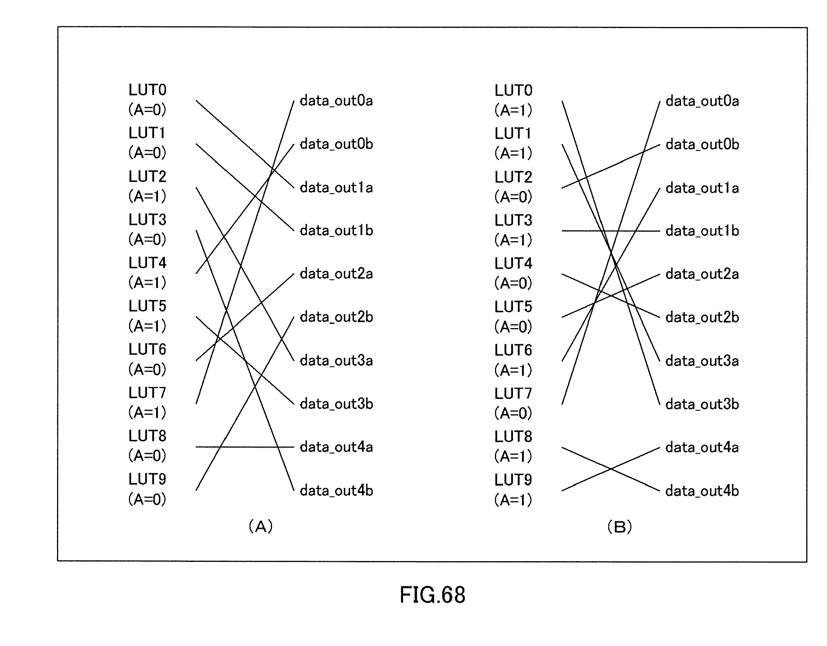

Input-side switch 901 is controlled by configuration selection section 905 to implement the configurations shown in FIG.68.

### <Read operation>

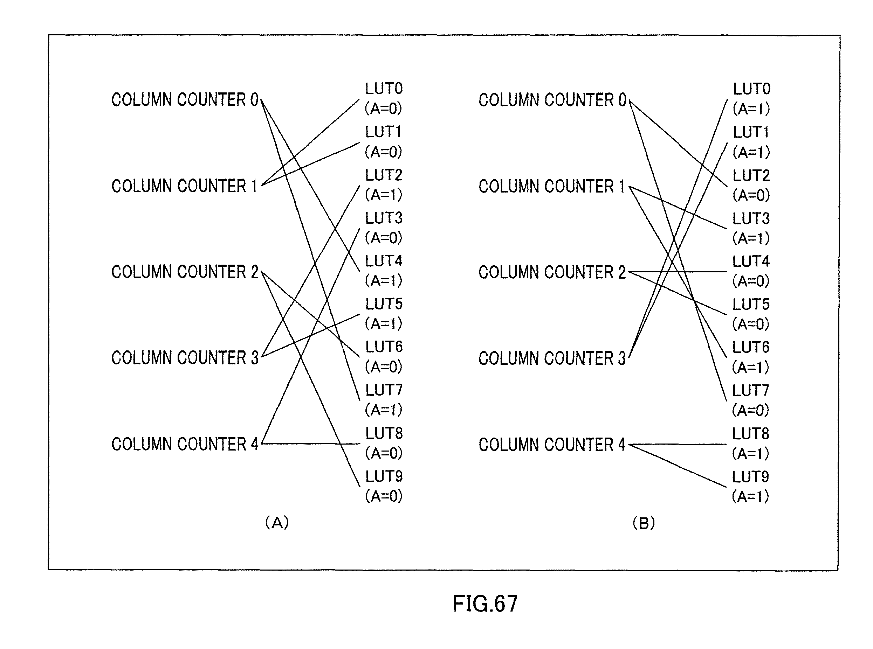

Initial values of row counters 906 and column counters 907 are the same as in Embodiment 4, since the sub-block size is the same. That is to say, the counter initial values are as shown in FIG.50.
In this embodiment, row counters 906 are incremented by 2 every cycle. As in the example in Embodiment 4, when a row counter value exceeds 19 it is reset (that is, decremented by 20), at which point a row counter 906 is incremented by 1.
Column number switch 908 performs connections so that one column counter value is sent to two LUTs, as shown in FIG.67.

Thus, two addresses are generated from one row counter/column counter pair, and two data items are read out simultaneously. As there are five pairs of counters, a total of 10 data items are read out. These are sent to appropriate terminals by output-side switch 903 (there being two terminals per sub-block).
According to the present invention, these 10 data reads out are all guaranteed to be accesses to different banks, and access contention does not occur.
Pruning determination by pruning determination section 913 is performed for each data, not for each sub-block. For example, only one of the two initial data of sub-block 0 is invalid.

### (Other embodiments)

(1) Another example of the configuration of row counters, column counters, and a column number switch Row counters, column counters, and a column number switch can be implemented using a different circuit configuration from those in the above-described embodiments. However, the object of supplying a column number to an LUT and generating a signal to control the output switch remains the same.

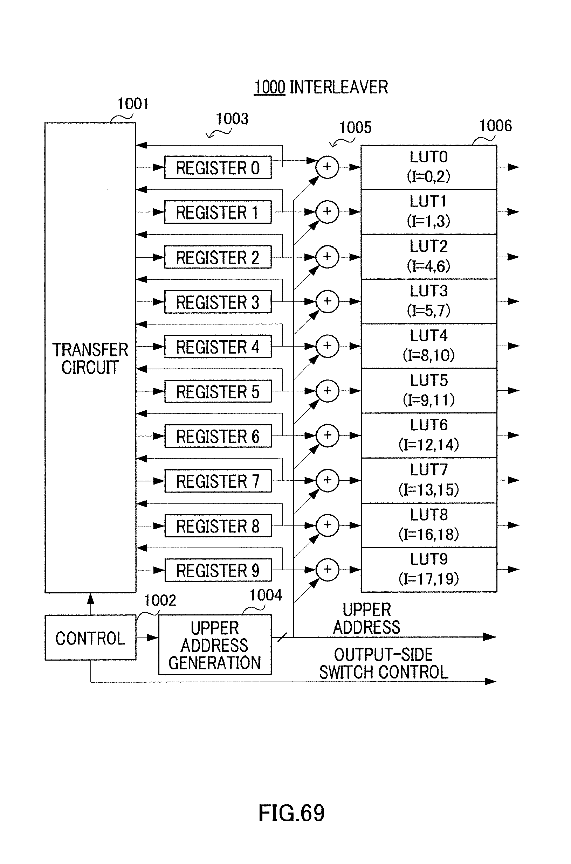

FIG.69 shows a variation of the circuit configuration of Embodiment 5 shown in FIG.54. FIG.69 shows only parts corresponding to row counters 807, column counters 808, column number switch 809, and address generation section 811 in FIG.54, and omits other parts of this interleaver 1000.

Instead of row counters 807, column counters 808, and column number switch 809, interleaver 1000 has a transfer circuit 1001, a control section 1002, a register section 1003, an upper address generation section 1004, and adders 1005.
Ten registers 0 through 9 hold values corresponding to values of column counters 808. In FIG. 54, the correspondence between column counters 808 and sub-blocks is fixed, whereas in FIG.69 the correspondence between registers 0 through 9 and LUT0 through LUT9 is fixed.
Transfer circuit 1001 permutes register contents. Value updating is performed for some registers.

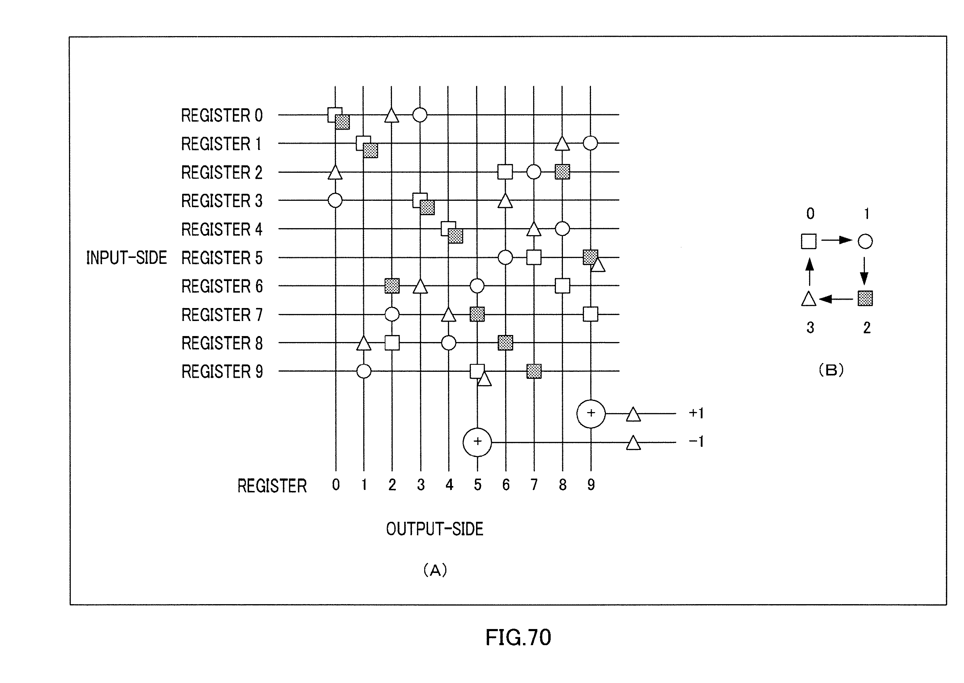

FIG.70 shows an example of the configuration of transfer circuit 1001. Transfer circuit 1001 has four states, and state transitions are shown in FIG.70 (B).
In state 0, parts indicated by white squares are connected. That is to say, register 0 contents are transferred to register 0, and register 9 contents are transferred to register 5.
The operation of transfer circuit 1001 can be understood through a comparison with FIG.62. That is to say, in FIG.62, the value input to LUT9 is the value of column counter 0. Then, at the next time, switch connections are changed so that the value of column counter 0 is transferred to LUT5, as shown in FIG.62 (B).
On the other hand, in FIG.70, in the initial state a value corresponding to column counter 0 is held in register 9 as the value to be input to LUT9. As this value is used by LUT5 at the next time, transfer circuit connections are made so that this value is transferred to register 5.
In state 3 (indicated by a triangle), 1 is added to a value input to register 9, and 1 is subtracted from a value input to register 5. This is equivalent to an operation whereby a column counter 707 is incremented/decremented in FIG.62.
Control section 1002 in FIG.69 controls the four states of transfer circuit 1001. Simultaneously with this, control section 1002 performs control of upper address generation section 1004 and the output-side switch.

### (2) First example of application to turbo decoder

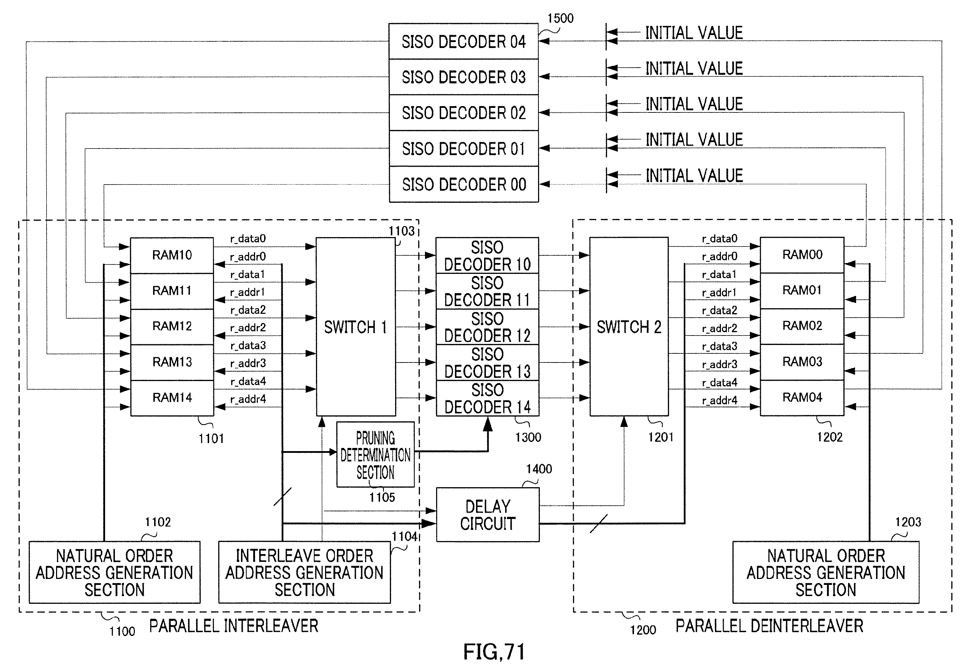

In Embodiment 3, sample configurations of parallel turbo decoders corresponding to the parallel interleavers in Embodiments 1 and 2 were shown (FIG.41 and FIG.42). FIG.71 shows a sample configuration of a parallel turbo decoder corresponding to interleaver 700 of Embodiment 4 (FIG.43).

The parallel turbo decoder in FIG.71 broadly comprises a parallel interleaver 1100, a parallel deinterleaver 1200, SISO decoders 1300, a delay circuit 1400, and SISO decoders 1500.
Parallel interleaver 1100 has memory 1101, a natural order address generation section 1102, a switch 1103, an interleave order address generation section 1104, and a pruning determination section 1105. Parallel deinterleaver 1200 has a switch 1201, memory 1202, and a natural order address generation section 1203.

Characteristics of the operation of the parallel turbo decoder in FIG.71 are as follows:
(i) If an invalid address is detected by pruning determination section 1105, only the relevant SISO decoder is made to wait (temporarily stopped).
(ii) As a parallel interleaver 1100 interleave order address can be used directly by parallel deinterleaver 1200 as long as timing adjustment is performed by delay circuit 1400, a single interleave order address generation section 1104 is sufficient. At the same time, a switch control signal is passed. By this means, the same address is passed at the same (simply delayed) timing, and therefore absence of access contention is guaranteed. When the data arrangement is the same in SISO decoder 1300 input and output, a FIFO (first-in, first-out) buffer is used as delay circuit 1400. When the data arrangements are reversed in input and output, a LIFO (last-in, first-out) buffer is used.

With regard to (i), a configuration has also conventionally been used whereby a SISO decoder is made to wait based on pruning determination. A characteristic of the present invention is that this is performed with a parallel configuration.

There are two examples of conventional configurations, as follows.
Conventional configuration 1: A serial (not parallel) turbo decoder is presupposed. Addresses are calculated one at a time rather than using table lookup (because an address table is large). At this time, invalid addresses are generated, in which case a SISO decoder is made to wait. To avoid the occurrence of waits, a method has also been devised whereby two addresses are generated at a time but only one is used, for instance. In this case, no two consecutive addresses are ever invalid. Conventional configuration 2: Address generation is performed by means of table lookup by a parallel interleaver. Although generation may be possible by a means other than table lookup, table lookup is mostly used. In any case, if a table is created, it is generally accepted that invalid addresses are pruned away.

In contrast, according to the present invention waits are expressly generated by pruning in a parallel turbo decoder. In other words, a table is created with invalid addresses retained. By this means, a state in which contention does not occur can be maintained.

### (3) Second example of application to turbo decoder

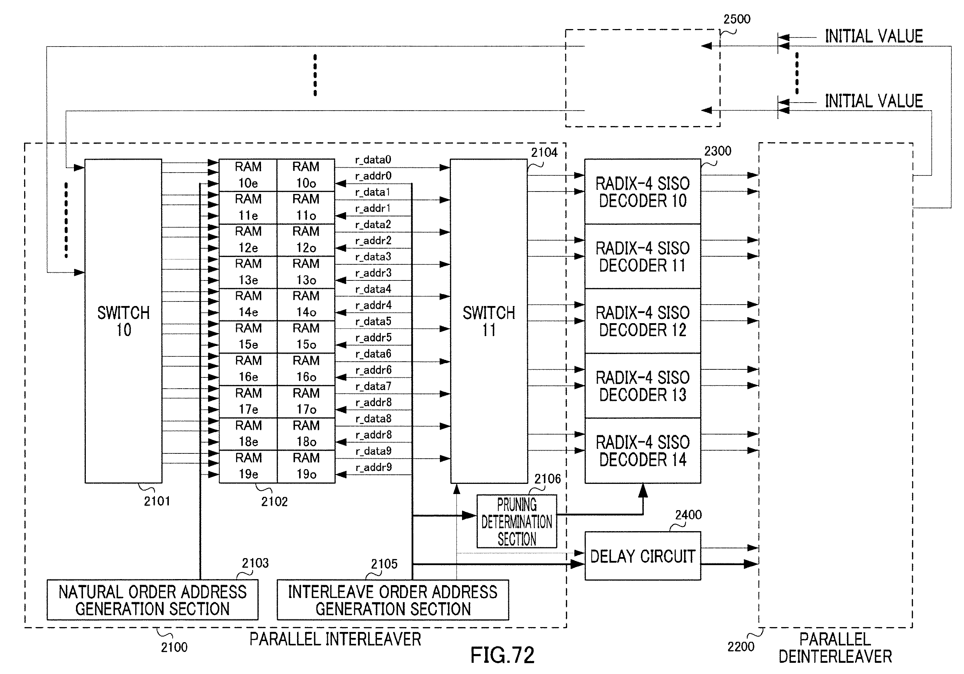

FIG.72 shows a sample configuration of a turbo decoder corresponding to hybrid interleaver 900 of Embodiment 6.

The turbo decoder in FIG.72 broadly comprises a parallel interleaver 2100, a parallel deinterleaver 2200, a Radix-4 SISO decoder 2300, a delay circuit 2400, and a Radix-4 SISO decoder 2500.
Parallel interleaver 2100 has a switch 2101, memory 2102, a natural order address generation section 2103, a switch 2104, an interleave order address generation section 2105, and a pruning determination section 2106.

Here, memory banks are further divided into two - even-numbered addresses and odd-numbered addresses - to enable 10-symbol/cycle writes in the natural order (at the time of parallel interleaver writing). Even-numbered address data is stored in RAMs with "e" appended, and odd-numbered address data in RAMs with "o" appended.
In the natural order, when a write is performed to RAM10e, data is also simultaneously written to RAM10o. In the interleave order, a read is performed on only one or the other of RAM10e and RAM10o.

As explained above, one aspect of a parallel interleaver of the present invention is a parallel interleaver, such as described using FIG.21, FIG.31, FIG.36, FIG.43, FIG.54, or FIG.63, for example, that implements an interleave algorithm by writing input data to memory composed of a plurality of memory banks and reading out written data in an order different from the write order, the algorithm writing data on a row-direction priority basis to a rectangular matrix data structure, performing intra-row permutation based on an intra-row permutation pattern stipulated for each row, permuting rows, and reading out data on a column-direction priority basis; and employs a configuration that includes: a memory composed of a plurality of memory banks, each bank being associated with one or a plurality of row numbers of the rectangular matrix; a pattern generation section that generates a plurality of intra-row permutation patterns stipulated in another row in the rectangular matrix data structure; and a read control section that has the pattern generation section inside and generates a plurality of read addresses based on the plurality of intra-row permutation patterns; and whereby a plurality of data are read out simultaneously from the memory.

According to this configuration, processing can be performed in parallel using a plurality of addresses without access contention, and an interleaver can be speeded up.

One aspect of a parallel interleaver of the present invention employs a configuration wherein the read control section reads out data from the plurality of memory banks so that, with regard to two or more data read out simultaneously between the memory banks, for any two or more, the remainder after the difference in post-interleaving data ranking is divided by the number of rows is 1 or more.

According to this configuration, since data of memory banks are read out so that the remainder after the difference in post-interleaving data ranking of data read out simultaneously between the memory banks is divided by the number of rows is 1 or more, two or more read addresses are not generated in the same memory bank no matter what kind of intra-row and inter-row permutation patterns are used. That is to say, memory bank memory access contention can be avoided no matter what kind of interleave pattern is used. As a result, a parallel interleaver can be implemented that enables high-speed interleave processing to be performed satisfactorily without providing additional circuitry such as an arbitration circuit.

One aspect of a parallel interleaver of the present invention employs a configuration wherein the interleave algorithm, when the data size of input data is smaller than the rectangular matrix, adds dummy data to the input data and performs interleave processing, and then prunes away the dummy data; and wherein an invalid address determination section is further provided that determines from zero to a plurality of invalid addresses corresponding to the dummy data among the plurality of addresses.

One aspect of a parallel interleaver of the present invention employs a configuration wherein the read control section reads out data from the plurality of memories so that, with regard to two or more data read out simultaneously between the memory banks, for any two or more, the remainder after the difference in data ranking before dummy data elimination is divided by the number of rows is 1 or more.

According to this configuration, two or more read addresses are not generated in the same memory bank even though dummy data elimination processing (pruning processing) is performed, making it possible to avoid memory access contention for memory banks even though interleaving is performed using an arbitrary data size.

One aspect of a parallel interleaver of the present invention employs a configuration wherein a write control section is provided that writes input data of each row in the rectangular matrix data structure to a memory bank for which data of the same row corresponds to that row number, and generates a write address for writing to a determined memory bank; and the write control section generates write addresses so that the correspondence between a row in the rectangular matrix data structure and a write destination bank is a one-to-one correspondence.

According to this configuration, the degree of parallelism can be made equal to the number of memory banks while avoiding memory bank access contention, enabling high-speed interleave processing to be performed by utilizing memory banks to the maximum.

One aspect of a parallel interleaver of the present invention employs a configuration wherein a write control section is provided that writes input data of each row in the rectangular matrix data structure to a memory bank for which data of the same row corresponds to that row number, and generates a write address for writing to a determined memory bank; and the correspondence of a write destination memory bank to a row in the rectangular matrix data structure is uniquely determined, and a write address is generated that associates one or a plurality of rows not exceeding the greatest common divisor of the difference in post-interleaving ranking and the number of rows with one memory bank.

According to this configuration, when the number of data read out simultaneously is smaller than the number of rows, the number of memorybanks canbe reduced, enabling a parallel interleaver to be implemented with smaller-scale circuitry.

One aspect of a parallel interleaver of the present invention employs a configuration wherein the write control section is provided with a row counter that generates a first row number set of the same number as the simultaneously read out data, and a column counter that generates a first column number set of the same number as the simultaneously read out data; a write destination bank is determined by the first row number set, and a write address is calculated from the first column number set; and the read control section is provided with an interleave address generation section that generates a plurality of interleave addresses corresponding to a plurality of data rankings such that the remainder after dividing the difference by the number of rows is 1 or more for any two, a column number determination section that calculates uniquely a second row number set and a second column number set for the interleave addresses, and an address transfer section that takes the second column number set as a read address, determines a read source bank by means of the second row number set, and sends the read address to the relevant read source bank.

One aspect of a parallel interleaver of the present invention employs a configuration wherein the read control section is provided with a bank selection signal generation section that finds the remainder after the post-interleaving ranking difference is divided by the number of rows as a row offset, converts a row number set composed of row numbers equivalent to the memory bank offset respectively by the relevant offset amount to an inter-row permutation pattern, and sends a post-conversion row number set to an output selection section provided on the output side of the memory as a bank selection signal, and a read address generation section that generates an intra-row permutation pattern using a column number set and a post-conversion row number set found by the bank selection signal generation section, and sends that pattern to a relevant memory bank of the memory as a read address.

According to this configuration, processing can be implemented by means of the read address generation section and bank selection signal generation section whereby data are read out so that, with regard to two or more data read out simultaneously between the memory banks, for any two or more, the remainder after the difference in data ranking before dummy data elimination is divided by the number of rows is 1 or more.

One aspect of a parallel interleaver of the present invention is a sub-block division type of interleaver in which the parallel interleaver has a write control section that generates a write address for writing input data of each row in the rectangular matrix data structure to a different memory bank in predetermined sub-block units; and employs a configuration wherein the read control section is provided with a bank selection signal generation section that finds the remainder after the post-interleaving ranking difference is divided by the number of rows as a row offset, converts a row number set composed of row numbers equivalent to the memory bank offset respectively by the relevant offset amount to an inter-row permutation pattern, and sends a post-conversion row number set to an output selection section provided on the output side of the memory as a bank selection signal, and a read address generation section that generates an intra-row permutation pattern using a column number set and a post-conversion row number set found by the bank selection signal generation section, and sends that pattern to a relevant memory bank of the memory as a read address.

According to this configuration, processing can be implemented by means of the read address generation section and bank selection signal generation section in a sub-block division type of interleaver whereby data are read out so that, with regard to two or more data read out simultaneously between the memory banks, for any two or more, the remainder after the difference in data ranking before dummy data elimination is divided by the number of rows is 1 or more.

One aspect of a parallel interleaver of the present invention employs a configuration wherein the write control section generates a write address such that the sub-block size of input data written to each memory bank is made greater than or equal to the number of columns in the rectangular matrix data structure.

According to this configuration, processing can be implemented, without causingmemoryaccess contention, whereby, in a sub-block type of interleaver, input data of each row in a rectangular matrix data structure is written to a memory bank for which data of the same row corresponds to that row number.

One aspect of a parallel interleaver of the present invention employs a configuration wherein the write control section generates a write address such that the sub-block size of input data written to each memory bank is made equal to the number of columns of the rectangular matrix data structure.

According to this configuration, processing can be performed in identical sub-block units for both writes and reads.

One aspect of a parallel interleaver of the present invention employs a configuration wherein reverse processing of an interleave algorithm is implemented by transposing a write address and a read address of any above-described parallel interleaver, and furthermore transposing an input selection section and an output selection section.

According to this configuration, data interleaved by any above-described parallel interleaver can be restored to its original arrangement without memory access contention.

One aspect of a turbo decoder of the present invention employs a configuration that includes any above-described parallel interleaver.

One aspect of an interleave method of the present invention is an interleave method that implements an interleave algorithm by writing input data to memory composed of a plurality of memory banks and reading out written data in an order different from the write order, the algorithm writing data on a row-direction priority basis to a rectangular matrix data structure, performing intra-row permutation based on an intra-row permutation pattern stipulated for each row, permuting rows, and reading out data on a column-direction priority basis; and includes: a pattern generation step of generating a plurality of intra-row permutation patterns stipulated in another row in the rectangular matrix data structure; and an address generation step of generating a plurality of read addresses for memory composed of a plurality of memory banks, each bank being associated with one or a plurality of row numbers of the rectangular matrix, based on the plurality of intra-row permutation patterns generated in the pattern generation step; and whereby a plurality of data are read out simultaneously from the memory.

The present application is based on Japanese Patent Application No.2005-28314 filed on February 3, 2005, entire content of which is expressly incorporated herein by reference.

### Industrial Applicability

A parallel interleaver, parallel deinterleaver, and interleave method of the present invention are suitable for application to a turbo decoder of a radio communication apparatus, for example.

## Claims

1. A parallel interleaver that implements an interleave algorithm by writing input data to a memory composed of a plurality of memory banks and reading written data in an order different from a write order the algorithmwriting data on a row-direction priority basis to a rectangular matrix data structure, performing intra-row permutation based on an intra-row permutation pattern stipulated for each row, permuting rows, and reading out data on a column-direction priority basis, wherein:
said parallel interleaver comprises:
a memory composed of a plurality of memory banks, each bank being associated with one or a plurality of row numbers of said rectangular matrix;
a pattern generation section that generates a plurality of intra-row permutation patterns stipulated in another row in said rectangular matrix data structure; and
a read control section that has said pattern generation section inside and generates a plurality of read addresses based on said plurality of intra-row permutation patterns, and
said parallel interleaver reads out a plurality of data simultaneously from said memory.

2. The parallel interleaver according to claim 1, wherein said read control section reads out data from said plurality of memory banks so that, with regard to two or more data read out simultaneously between said memory banks, for any two or more, a remainder after a difference in post-interleaving data ranking is divided by a number of rows is 1 or more.

3. The parallel interleaver according to claim 1, wherein:
said interleave algorithm, when a data size of input data is smaller than said rectangular matrix, adds dummy data to said input data and performs interleave processing, and then prunes away said dummy data; and
said parallel interleaver further comprises an invalid address determination section that determines from zero to a plurality of invalid addresses corresponding to said dummy data among said plurality of addresses.

4. The parallel interleaver according to claim 3, wherein said read control section reads out data from said plurality of memories so that, with regard to two or more data read out simultaneously between said memory banks, for any two or more, a remainder after a difference in data ranking before dummy data elimination is divided by a number of rows is 1 or more.

5. The parallel interleaver according to claim 1, further comprising a write control section that writes input data of each row in said rectangular matrix data structure to a memory bank for which data of a same row corresponds to that row number, and generates a write address for writing to a determined memory bank,
wherein said write control section generates write addresses so that correspondence between each row in said rectangular matrix data structure and a write destination bank is a one-to-one correspondence.

6. The parallel interleaver according to claim 1, further comprising a write control section that writes input data of each row in said rectangular matrix data structure to a memory bank for which data of a same row corresponds to that row number, and generates a write address for writing to a determined memory bank,
wherein said write control section uniquely determines correspondence of a write destination memory bank to a row in said rectangular matrix data structure, and generates a write address that associates one or a plurality of rows not exceeding a greatest common divisor of a difference in post-interleaving ranking and a number of rows with one memory bank.

7. The parallel interleaver according to claim 1, further comprising a write control section that writes input data of each row in said rectangular matrix data structure to a memory bank for which data of a same row corresponds to that row number, and generates a write address for writing to a determined memory bank, wherein:
said write control section comprises:
a row counter that generates a first row number set of a same number as said simultaneously read data; and
a column counter that generates a first column number set of a same number as said simultaneously read out data,
and determines a write destination bank by said first row number set, and calculates a write address from said first column number set; and
said read control section comprises:
an interleave address generation section that generates a plurality of interleave addresses corresponding to a plurality of data rankings such that a remainder after dividing a difference by a number of rows is 1 or more for any two;
a column number determination section that calculates uniquely a second row number set and a second column number set for said interleave addresses; and
an address transfer section that takes said second column number set as a read address, determines a read source bank by means of said second row number set, and sends said read address to a relevant read source bank.

8. The parallel interleaver according to claim 1, wherein said read control section comprises:
a bank selection signal generation section that finds a remainder after a post-interleaving ranking difference is divided by a number of rows as a row offset, converts a row number set composed of row numbers equivalent to said memory bank offset respectively by a relevant offset amount to an inter-row permutation pattern, and sends a post-conversion row number set to an output selection section provided on an output side of said memory as a bank selection signal; and
a read address generation section that generates an intra-row permutation pattern using a column number set and a post-conversion row number set found by said bank selection signal generation section, and sends that pattern to a relevant memory bank of said memory as a read address.

9. The parallel interleaver according to claim 1, wherein:
said parallel interleaver is a sub-block division type of interleaver having a write control section that generates a write address for writing input data of each row in the rectangular matrix data structure to a different memory bank in predetermined sub-block units; and
said read control section comprises:
a bank selection signal generation section that finds a remainder after a post-interleaving ranking difference is divided by a number of rows as a row offset, converts a row number set composed of row numbers equivalent to said memory bank offset respectively by a relevant offset amount to an inter-row permutation pattern, and sends a post-conversion row number set to an output selection section provided on an output side of said memory as a bank selection signal; and
a read address generation section that generates an intra-row permutation pattern using a column number set and a post-conversion row number set found by said bank selection signal generation section, and sends that pattern to a relevant memory bank of said memory as a read address.

10. The parallel interleaver according to claim 9, wherein said write control section generates a write address such that a sub-block size of input data written to said each memory bank is made greater than or equal to a number of columns in said rectangular matrix data structure.

11. The parallel interleaver according to claim 8, wherein said write control section generates a write address such that a sub-block size of input data written to said each memory bank is made equal to a number of columns of said rectangular matrix data structure.

12. A parallel interleaver that implements reverse processing of an interleave algorithm by transposing a write address and a read address of the parallel interleaver according to claim 1, and furthermore transposing an input selection section and an output selection section.

13. A turbo decoder comprising the parallel interleaver according to claim 1.

14. An interleave method that implements an interleave algorithm by writing input data to memory composed of a plurality of memory banks and reading out written data in an order different from a write order, the algorithm writing data on a row-direction priority basis to a rectangular matrix data structure, performing intra-row permutation based on an intra-row permutation pattern stipulated for each row, permuting rows, and reading out data on a column-direction priority basis, wherein:
said interleave method comprises:
a pattern generation step of generating a plurality of intra-row permutation patterns stipulated in another row in said rectangular matrix data structure; and
an address generation step of generating a plurality of read addresses for memory composed of a plurality of memory banks, each bank being associated with one or a plurality of row numbers of said rectangular matrix, based on said plurality of intra-row permutation patterns generated in said pattern generation step, and
a plurality of data are read out simultaneously from said memory.
